(19) 

(11) **EP 4 382 250 B1**

(12) **EUROPEAN PATENT SPECIFICATION**

(45) Date of publication and mention of the grant of the patent:
**30.09.2026 Bulletin 2026/40**

(21) Application number: **22852995.4**

(22) Date of filing: **01.08.2022**

(51) International Patent Classification (IPC):
***B24B 37/26*** *(2012.01)* *B24B 37/24* *(2012.01)*

(52) Cooperative Patent Classification (CPC):
**B24B 37/26;** B24B 37/24

(86) International application number:
**PCT/JP2022/029479**

(87) International publication number:
**WO 2023/013576 (09.02.2023 Gazette 2023/06)**

(54) **POLISHING PAD**

POLIERKISSEN

TAMPON À POLIR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.08.2021 JP 2021128004**

(43) Date of publication of application:
**12.06.2024 Bulletin 2024/24**

(73) Proprietor: **Kuraray Co., Ltd.**
**Kurashiki-shi, Okayama 710-0801 (JP)**

(72) Inventors:
- **SUNAYAMA, Azusa**
  **Kurashiki-shi, Okayama 713-8550 (JP)**
- **KATO, Mitsuru**
  **Kurashiki-shi, Okayama 713-8550 (JP)**
- **TAKEGOSHI, Minori**
  **Kurashiki-shi, Okayama 713-8550 (JP)**

(74) Representative: **Vossius & Partner Patentanwälte Rechtsanwälte mbB**
**Siebertstrasse 3**
**81675 München (DE)**

(56) References cited:
**EP-A1- 3 823 012**
**CN-B- 106 564 004**
**CN-U- 205 996 788**
**JP-A- 2000 237 950**
**JP-A- 2005 183 708**
**JP-A- 2020 009 987**
**TW-A- 201 217 103**
**TW-U- M 612 568**
**US-A1- 2019 389 033**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 382 250 B1

## Description

[Technical Field]

The present invention relates to a polishing pad that can be preferably used for chemical mechanical polishing (CMP).

[Background Art]

Conventionally, chemical mechanical polishing (CMP), which involves polishing a material to be polished by pressing the material against a polishing pad, while adding dropwise a polishing slurry (hereinafter may also be simply referred to as a "slurry") to the polishing surface of the polishing pad, has been used in order to mirror-finish substrate materials of a semiconductor and a silicon wafer, or glass, which is a material of a hard disk, a liquid crystal display, and a lens, and to planarize irregularities caused by an insulating film or a metal film in the manufacturing process of semiconductor devices.

Grooves such as spiral grooves, concentric grooves, grid-like grooves, or radial grooves are formed on a CMP polishing pad in order to evenly retain a slurry in a polishing surface, discharge polishing debris, or prevent damage caused by adsorption of a material to be polished.

For example, PTL 1 listed below discloses a semiconductor wafer polishing pad including: a portion coming into contact with a central part of a wafer during polishing, the portion having formed therein a plurality of radial grooves extending from the center toward the outer periphery; and a portion coming into contact with at least a peripheral part of the wafer, the portion having formed therein a plurality of circular grooves concentric with the polishing pad. PTL 1 also discloses that the portion having the radial grooves formed therein has a width that is substantially 1/2 the diameter of the wafer.

For example, PTL 2 listed below discloses a polishing pad including a polishing layer having a polishing-side surface on which radial grooves and concentric grooves are open so as to share the center and intersect each other, wherein if intersection portions between the radial grooves and the concentric grooves belong to the radial grooves, the radial grooves and the concentric grooves satisfy: condition (A) that the ratio of an area (s1) of the radial grooves to a sum (s1+s2) of the area (s1) of the radial grooves and an area (s2) of the concentric grooves is 8 to 17%; and condition (B) that the ratio of the sum (s1+s2) of the area (s1) of the radial grooves and the area (s2) of the concentric grooves to an area (S) of the polishing-side surface is 18 to 25%.

For example, PTL 3 listed below discloses a polishing pad including: a polishing layer having a center, a peripheral edge, a radius extending from the center to the peripheral edge, and a polishing track surrounding the center and intersecting the radius; and a plurality of feeder grooves ($\delta$) intersecting the radius, wherein the polishing pad has land areas between the feeder grooves ($\delta$) for planarizing a material to be polished. Also, the polishing pad includes a plurality of feeder grooves ($\delta$) having an average cross-sectional feeder area ($\delta_a$), and at least one radial drainage groove ($\rho$) in the polishing layer that intersects the plurality of feeder grooves ($\delta$) for allowing a polishing fluid to flow from the plurality of feeder grooves ($\delta$) to the at least one radial drainage groove ($\rho$). Also, in the polishing pad, the radial drainage groove ($\rho$) has an average drainage cross-sectional area ($\rho_a$), the average drainage cross-sectional area ($\rho_a$) of the radial drainage groove is greater than the average cross-sectional feeder area ($\delta_a$) according to $2 \times \delta_a \leq \rho_a \leq 8 \times \delta_a$, $(0.15)n_f \times \delta_a \leq n_r \times \rho_a \leq (0.35)n_f \times \delta_a$ (where ($n_r$) represents the number of radial grooves, and ($n_f$) represents the number of feeder grooves), and the radial drainage groove ($\rho$) extends through the polishing track for facilitating polishing debris removal through the polishing track and underneath at least one of a semiconductor substrate, an optical substrate, and a magnetic substrate and then beyond the polishing track toward the peripheral edge of the polishing pad during rotation of the polishing pad.

For example, PTL 4 listed below discloses a polishing pad including: a central track having a rotation center at a center of a polishing layer, and an arrangement center having a distance from the rotation center; annular grooves including a plurality of annular grooves arranged concentrically around the center; and radially extending grooves, wherein the central track is provided with a plurality of crossing points.

For example, PTL 5 listed below discloses a polishing pad including a first region that does not extend to the center of the polishing layer, and in which radially extending grooves and annular grooves coexist; and a second region in which only annular grooves exist, wherein the radius of the first region is 30 to 70% of the radius of the polishing pad.

For example, PTL 6 listed below discloses a polishing pad including a polishing layer and a surface pattern. The surface pattern is disposed in the polishing layer, and includes a plurality of radially extending grooves. The radially extending grooves are divided into at least two radially extending groove groups. A blanking area is disposed between the at least two radially extending groove groups. The spaces between two adjacent radially extending grooves located with the same radially extending groove group are the same. The radially extending grooves on the two sides located with the same radially extending groove group have the shortest extending length.

For example, PTL 7 listed below relates to a polishing pad comprising a polishing layer, wherein the abrasive

layer comprises a central region, an edge region, and a main polishing region located between the central region and the edge region; at least one annular groove located in said primary abrasive area of said abrasive layer; an edge trench located in the edge region of the abrasive layer and the edge trench comprising a lattice-like trench; and at least one radially extending groove located in said primary abrasive region of said abrasive layer and said radially extending trench being connected to said at least one annular groove.

[Citation List]

[Patent Literatures]

[PTL 1] Japanese Laid-Open Patent Publication No. 2000-237950
[PTL 2] Japanese Laid-Open Patent Publication No. 2011-177884
[PTL 3] Japanese Laid-Open Patent Publication No. 2017-208530
[PTL 4] TW M459065 U1
[PTL 5] TW I548484
**[PTL 6]** TW M612568 U
**[PTL 7]** CN 205996788 U


[Summary of Invention]

[Technical Problem]

In CMP, there is a need for a polishing pad that achieves a higher polishing rate. It is an object of the present invention to provide a polishing pad for achieving a high CMP polishing rate.

[Solution to Problem]

One aspect of the present invention relates to a polishing pad comprising a polishing layer having a circular polishing surface. The polishing surface comprises a central region corresponding to a range of 0 to 10% of a radius of the polishing surface from a center of the polishing surface, and a peripheral edge region corresponding to a range of 90 to 100% of the radius of the polishing surface from the center of the polishing surface, and the polishing layer comprises: at least one spiral groove or concentric grooves including a plurality of annular grooves arranged concentrically, the at least one spiral groove and the concentric grooves being disposed spanning from the central region to the peripheral edge region; and radial grooves including at least two line segment-shaped grooves extending from the central region toward the peripheral edge region. A center of the spiral groove, a center of the concentric grooves, and a center of the radial grooves are present in the central region, the line segment-shaped grooves have an average length of 30 to 65% of the radius of the polishing surface, and have a first end portion in a region at a distance of 5 to 10% of the radius of the polishing surface from the center of the radial grooves and a second end portion in a region at a distance of 35 to 70% of the radius of the polishing surface from the center of the radial grooves. A cross-sectional area Sa ($mm^2$), which is an average cross-sectional area of cross sections of the line segment-shaped grooves in a direction perpendicular to a length direction of the line segment-shaped grooves, and a cross-sectional area Sb ($mm^2$), which is an average cross-sectional area of cross sections of the spiral groove or the concentric grooves in a direction perpendicular to a tangential direction of the spiral groove or the concentric grooves, satisfy $0.1 \leq Sb/Sa < 1.0$.

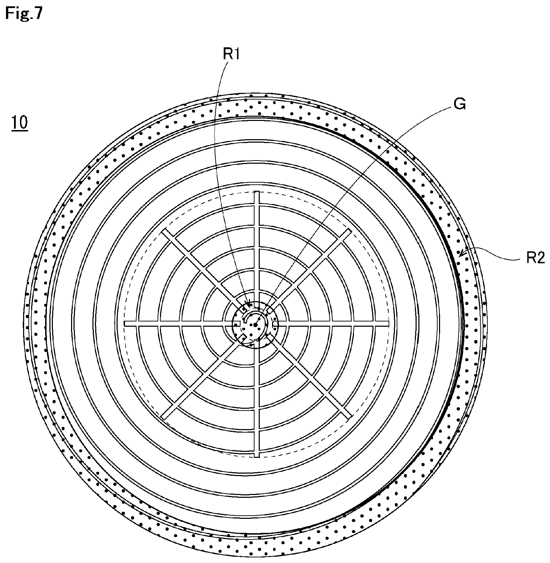

Here, a "polishing surface" refers to a surface of a polishing layer that comes into contact with a material to be polished. With reference to FIG. 7, for example, a "central region" refers to a circular region R1, which is a dotted region corresponding to a range of 0 to 10% of the radius of the circular polishing surface from the center G of the circular polishing surface. A "peripheral edge region" refers to a region corresponding to a range of 90 to 100% of the radius of the circular polishing surface from the center of the circular polishing surface, more specifically, a dotted, band-shaped region R2 extending along a circular peripheral edge that corresponds to 90 to 100% of the radius.

A "line segment-shaped groove" refers to a linear groove that does not reach the peripheral edge of the polishing surface and has both ends in the plane of the polishing surface. A spiral groove is at least one spiral groove having a spiral center in a central region in the polishing surface. Concentric grooves are grooves including a plurality of concentrically arranged annular grooves that have a common center in the central region in the polishing surface. The expression "a spiral groove or concentric grooves being disposed spanning from the central region to the peripheral edge region" means that at least one spiral groove or a plurality of annular grooves arranged concentrically are evenly formed spanning from the central region to the peripheral edge region of the polishing surface. Specifically, in the case of the concentric grooves, the

above expression means that the groove that is closest to the center passes through the central region, and the outermost groove passes through the peripheral edge region. In the case of the spiral groove, the above expression means that the start point of the spiral groove is present in the central region, and the end point of the spiral groove is present in the peripheral edge region. A "polishing region" refers to a region in the polishing surface that polishes the material to be polished, the polishing region coming into contact with a surface to be polished of the polishing surface of a material to be polished, which is a silicon wafer or the like.

In such a polishing pad, the plurality of line segment-shaped grooves suppress the slurry that has been added dropwise onto the polishing surface and accumulated in the vicinity of the central region from leaking out of the system from the peripheral edge of the polishing surface, while appropriately supplying the slurry to the spiral groove or the concentric grooves formed spanning from the central region to the peripheral edge region. As a result, the slurry is efficiently supplied to the polishing region, thus achieving a high polishing rate.

In the polishing pad, preferably $0.25 \leq Sb/Sa \leq 0.85$, more preferably $0.44 \leq Sb/Sa \leq 0.80$ is satisfied from the viewpoint of achieving a higher polishing rate, and excellent polishing uniformity in the surface to be polished of the material to be polished.

In the polishing pad, it is preferable that a groove width Wa (mm), which is an average width of the line segment-shaped grooves, and a groove width Wb (mm), which is an average width of the spiral groove or the concentric grooves, satisfy $0.1 \leq Wb/Wa < 1.0$. In such a case, the slurry can be more evenly retained by the polishing region, and thus a higher polishing rate can be achieved.

In the polishing pad, it is preferable that a groove width Wb (mm), which is an average width of the spiral groove or the concentric grooves, and an average groove pitch P (mm) of the spiral groove or the concentric grooves, satisfy $0.02 \leq Wb/P \leq 0.25$. In such a case, a sufficient area for the land area that comes into contact with the material to be polished can be secured, and a sufficient amount of the slurry can be supplied to the land area. Accordingly, a higher polishing rate can be achieved. Note that a "groove pitch P" refers to an average of the total of the groove intervals and the groove widths of adjacent spiral turns in the case of including the spiral groove, and adjacent annular grooves in the case of including the concentric grooves.

In the polishing pad, it is preferable that a groove width Wa (mm), which is an average width of the line segment-shaped grooves, a groove width Wb (mm), which is an average width of the spiral groove or the concentric grooves, and an average groove pitch P (mm) of the spiral groove or the concentric grooves, satisfy $0.2 \leq \{Wb^2/(P \times Wa)\} \times 100 \leq 25$. In such a case, a higher polishing rate can be achieved by swiftly supplying the slurry to the polishing region, and causing the slurry to be sufficiently retained between the polishing surface and the surface to be polished of the material to be polished.

In the polishing pad, it is preferable that the polishing layer comprises a thermoplastic polyurethane because of reduced scratching and easy moldability. It is preferable that the polishing layer is a non-foam because of excellent stability in the polishing rate and easy moldability.

[Advantageous Effects of Invention]

According to the present invention, it is possible to obtain a polishing pad that can easily increase a CMP polishing rate.

[Brief Description of Drawings]

[FIG. 1] FIG. 1 is a schematic plan view showing the polishing surface side of a polishing layer 1 of a polishing pad 10 including a spiral groove according to an embodiment.

[FIG. 2] FIG. 2 is a schematic plan view showing the polishing surface side of a polishing layer 11 of a polishing pad 20 including concentric grooves according to an embodiment.

[FIG. 3A] FIG. 3A is a schematic view showing a cross section, in a direction perpendicular to a tangential direction, of the spiral groove or the concentric grooves.

[FIG. 3B] FIG. 3B is a schematic view of a groove cross section for illustrating an angle of an inclined surface formed by chamfering corners of a groove.

[FIG. 3C] FIG. 3C is a schematic view showing a groove cross section having an inverse trapezoidal cross section for illustrating an angle of an inclined surface.

[FIG. 4] FIG. 4 is a schematic view showing a cross section, in a direction perpendicular to the length direction, of a line segment-shaped groove.

[FIG. 5] FIG. 5 is a schematic partial cross-sectional view showing a cross section in the thickness direction of the polishing pad 10 or the polishing pad 20.

[FIG. 6] FIG. 6 is an explanatory view for illustrating CMP.

[FIG. 7] FIG. 7 is an explanatory view for illustrating a central region and a peripheral edge region of a polishing surface.

[Description of Embodiment]

A polishing pad according to the present embodiment will be described in detail with reference to the drawings.

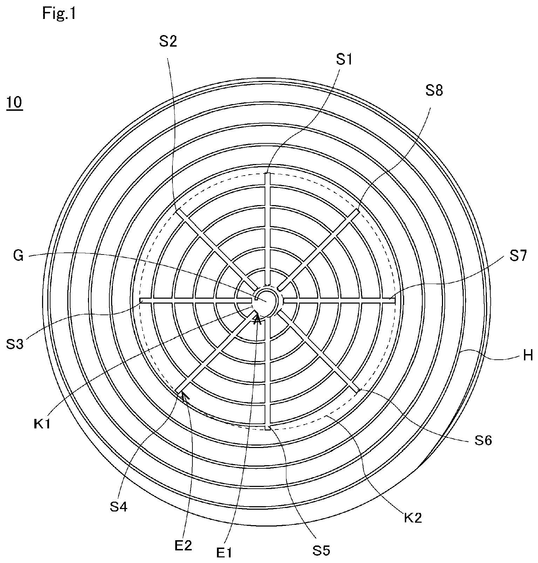

FIG. 1 is a schematic plan view showing a polishing surface of an example of a polishing pad according to the present embodiment, namely, a polishing pad 10 that includes a polishing layer 1 having a circular polishing surface including one spiral groove H formed spanning from a central region to a peripheral edge region, and radial grooves including eight line segment-shaped grooves S1 to S8 extending from the central region toward the peripheral edge region.

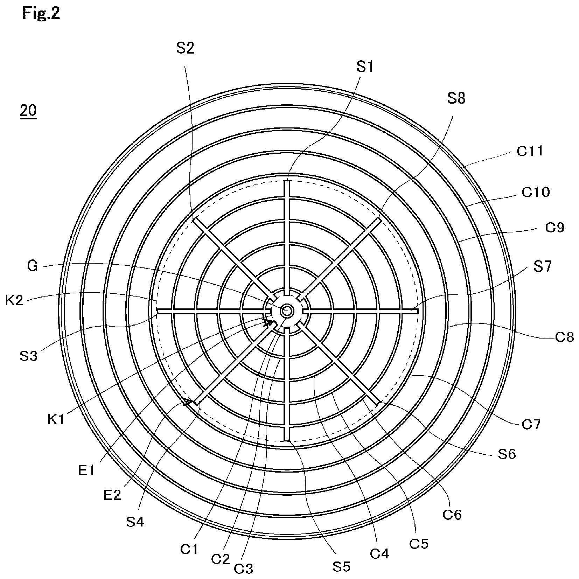

FIG. 2 is a schematic plan view showing a polishing surface of another example of the polishing pad according to the present embodiment, namely, a polishing pad 20 that includes a polishing layer 11 having a circular polishing surface including eleven concentrically arranged annular grooves C1 to C11 formed spanning from a central region to a peripheral edge region, and radial grooves including eight line segment-shaped grooves S1 to S8 extending from the central region toward the peripheral edge region.

FIG. 7 is an explanatory view for illustrating a central region R1 and a peripheral edge region R2 of the polishing pad 10. In the polishing pad 10 shown in FIG. 7, a dotted, circular region corresponding to a range of 0 to 10% of the radius of the circular polishing surface from a center G of the polishing surface is the central region R1, and a region corresponding to a range of 90 to 100% of the radius of the polishing surface from the center of the polishing surface, more specifically, a dotted, band-shaped region extending along a circular peripheral edge that corresponds to 90 to 100% of the radius is the peripheral edge region R2.

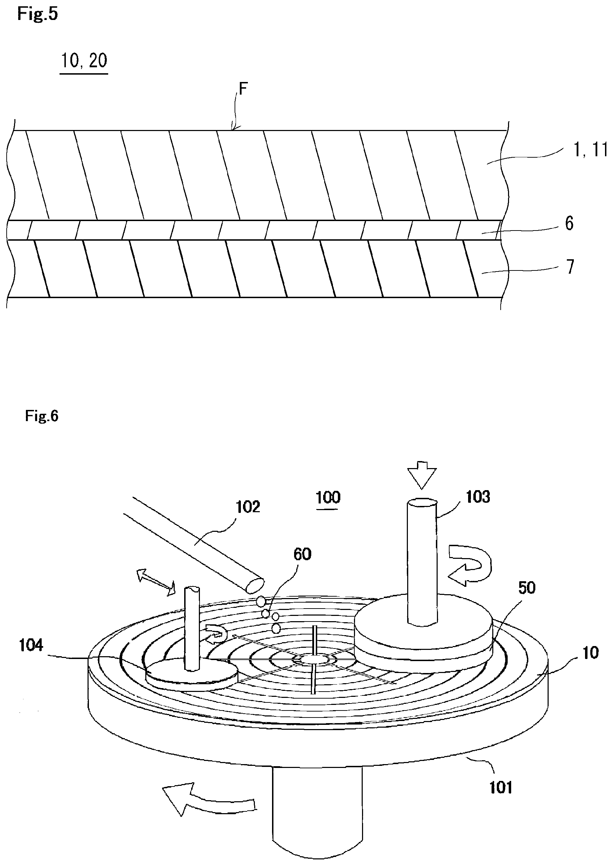

FIG. 5 is a schematic partial cross-sectional view showing a cross section in a thickness direction for illustrating a layer configuration of the polishing pad 10 or the polishing pad 20. The polishing pad 10 or the polishing pad 20 has a layered structure in which a cushioning layer 7 is bonded to a surface of the polishing layer 1 or 11 that is opposite to a polishing surface F with an adhesion layer 6 interposed therebetween. Note that the polishing pad according to the present embodiment is not limited to a polishing pad having such a layered structure, and may be a single-layer polishing pad composed only of a polishing layer having a polishing surface.

Referring to FIG. 1, in the polishing pad 10, the polishing surface of the polishing layer 1 has a circular shape. Also, with the center G of the polishing surface that is included in the central region as a spiral center, one spiral groove H disposed spanning from the central region to the peripheral edge region is formed on the polishing surface. In addition, with the center G as a radial center, radial grooves including eight line segment-shaped grooves S1 to S8 extending from the central region toward the peripheral edge region are formed. In this manner, the spiral groove H and the radial grooves share the center on the polishing pad 10.

Referring to FIG. 2, in the polishing pad 20, the polishing layer 11 has a circular polishing surface. Also, with the center G of the polishing surface that is included in the central region as a common center, eleven annular grooves C1 to C11 in the form of annular concentric circles disposed spanning from the central region to the peripheral edge region are formed on the polishing surface. In addition, with the center G as a radial center, radial grooves including eight line segment-shaped grooves S1 to S8 extending from the central region toward the peripheral edge region are formed. In this manner, the annular grooves C1 to C11 and the radial grooves share the center on the polishing pad 20.

On the polishing pad 10 and the polishing pad 20, the center G, which serves as a rotation center, of the circular polishing surface and the center of the spiral groove or the concentric grooves coincide with each other. In such a case, the slurry flows in a more uniform manner. Note that the polishing pad according to the present embodiment may include an eccentric spiral groove, concentric grooves, or radial grooves in which the center of the polishing surface and the center of the spiral groove, the concentric grooves, or the radial grooves do not coincide with each other. Inclusion of eccentric spiral groove or concentric grooves is preferable in that the shape transfer of the groove(s) to the surface to be polished of the material to be polished, such as a wafer, which may be caused by excessive polishing along the groove(s) can be easily suppressed.

As the diameter of the circular polishing surface, any diameter of the polishing surface of a circular polishing pad commonly used for CMP can be used, and the diameter is preferably about 500 to 780 mm, for example. Therefore, the radius of the circular polishing surface is preferably about 250 to 390 mm, for example.

In the polishing pad 10 or the polishing pad 20, a portion in which the line segment-shaped grooves S1 to S8, and the spiral groove H or the concentric annular grooves C1 to C11 are not formed constitutes a land area that polishes the surface to be polished of the material to be polished by coming into contact therewith. The polishing pad 10 and the polishing pad 20 are the same except for the difference between the spiral groove H and the concentric annular grooves C1 to C11. The spiral groove H is formed on the polishing pad 10 shown in FIG. 1, and the concentric annular grooves C1 to C11 are formed on the polishing pad 10 shown in FIG. 2. In the polishing pad according to the present embodiment, a combination of the spiral groove and the concentric annular grooves may be formed.

Thus, the polishing pad according to the present embodiment includes a spiral groove or concentric grooves formed spanning from the central region to the peripheral edge region.

In this manner, it is preferable that the spiral groove or the concentric grooves formed spanning from the central region of the polishing surface to the peripheral edge region thereof are formed over a region corresponding to 5 to 90%, more preferably 4.5 to 95%, and particularly preferably 4 to 100% of the radius of the polishing surface from the spiral center or the center of the concentric circles.

Referring to FIG. 1, in the polishing pad 10, a spiral groove H having a uniform groove pitch and a number of turns of 10 are formed in a region extending over at least 5 to 90% of the radius of the polishing surface from the spiral center that coincides with the center G included in the central region of the polishing surface of the polishing layer 1. Note that a spiral having a uniform groove pitch is also called an Archimedean spiral. Also, sections of the spiral groove H that correspond to the first to sixth spiral turns intersect the line segment-shaped grooves S1 to S8 to form 41 intersection portions.

In the polishing layer in which the spiral groove is formed in this manner, it is preferable that the start point is within a region corresponding to preferably 5% or less, more preferably 4.5% or less, and particularly preferably 4% or less of the radius from the center of the polishing surface, and that the end point reaches a peripheral edge in a region corresponding to 90% or more, more preferably 95% or more, and particularly preferably 100% of the radius. Since the spiral groove is formed over substantially the entire region so as to span from the central region to the peripheral edge region of the polishing surface in this manner, the slurry can be evenly delivered throughout the polishing region.

The spiral groove may be one spiral groove, or two or more spiral grooves including a plurality of spiral grooves that are arranged side by side. Specifically, the number of spiral grooves arranged side by side is preferably 1 to 16, and more preferably 1 to 10.

Referring to FIG. 2, in the polishing pad 20, concentric annular grooves C1 to C11 having a uniform groove pitch are formed in a region extending over at least 5 to 90% of the radius of the polishing surface from the center of the concentric circles that coincides with the center G included in the central region of the polishing surface of the polishing layer 11. Also, the annular grooves C2 to C6 of the annular grooves C1 to C11 intersect the line segment-shaped grooves S1 to S8 to form 40 intersection portions.

In the polishing layer in which the concentric grooves are formed in this manner, it is preferable that the concentric grooves are formed such that the annular groove closest to the center of the polishing surface passes through a region corresponding to preferably 5% or less, more preferably 4.5% or less, and particularly preferably 4% or less of the radius from the center of the polishing surface, and that the outermost groove passes through a region corresponding to preferably 90% or more, and more preferably 95% or more of the radius from the center of the polishing surface.

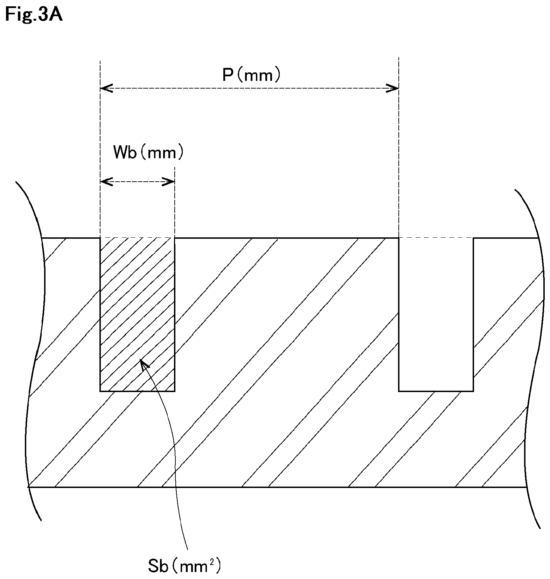

The groove pitch, which is an interval between adjacent sections of the spiral groove or adjacent grooves of the concentric grooves is not particularly limited. However, referring to FIG. 3A, a groove pitch P (mm), which is an average interval between adjacent sections or grooves is preferably 1 to 15 mm, more preferably 2 to 12 mm, and particularly preferably 2 to 10 mm. When the groove pitch P of the spiral groove or the concentric grooves is too large, the amount of the slurry supplied to the land area from the spiral groove or the concentric grooves tends to be insufficient. When the groove pitch P is too small, the proportion of the land area tends to be too low, resulting in a reduced polishing rate.

The cross-sectional shape of the spiral groove or the concentric grooves is not particularly limited. Specifically, a quadrangular shape such as a rectangular shape, a square shape, a trapezoidal shape, or an inverse trapezoidal shape, a triangular shape, a semi-circular shape, a semi-oval shape and so forth can be used as the shape of a cross section of the spiral groove or the concentric grooves in a direction perpendicular to the tangential direction thereof, without any particular limitation. Among these, a quadrangular shape is preferable because of the excellent processability, slurry retention, and supply stability.

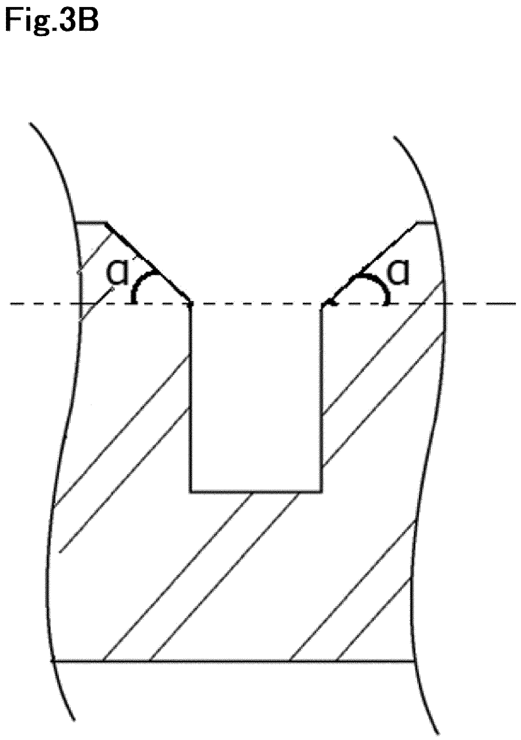

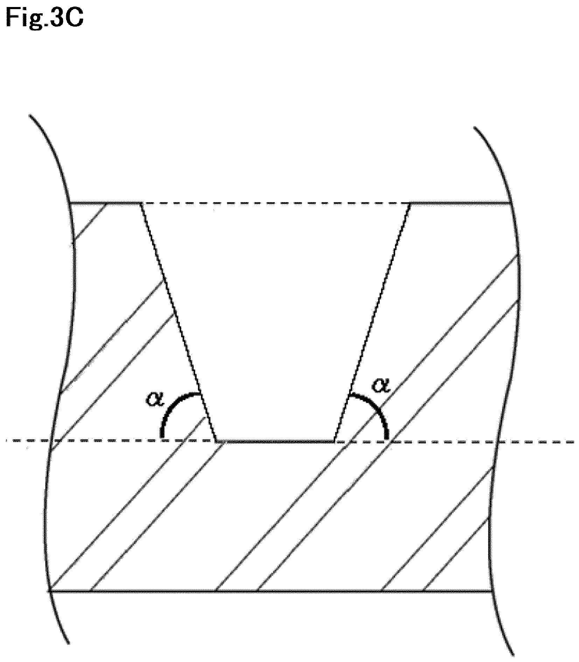

The spiral groove or the concentric grooves preferably have a cross section inclined such that the groove or grooves are reverse-tapered toward an opening thereof in order to suppress generation of burrs during polishing. Specifically, it is preferable that the cross section is a so-called Y-shaped cross section having tapered portions formed by chamfering two corners forming a quadrangular groove located on the polishing surface such that the corners are inclined at a predetermined angle $\alpha$ as shown in FIG. 3B, or an inverse trapezoidal cross section formed such that oblique sides are inclined at a predetermined angle $\alpha$ to two corners forming a base angle as shown in FIG. 3C. Such an inclination angle is not particularly limited, but is preferably 20 degrees to less than 90 degrees, more preferably 25 to 80 degrees, and particularly preferably 30 to 75 degrees. In particular, when the angle is 30 to 80 degrees, burrs, which are likely to be generated at corner portions of each groove during polishing, can be easily suppressed, and thus a reduction in the polishing rate and a reduction in the polishing uniformity can be easily suppressed.

Referring to FIG. 3A, as for the width of the spiral groove or the concentric grooves, a groove width Wb (mm), which is an average width of the groove or grooves, is preferably 0.1 to 4 mm, and more preferably 0.2 to 2 mm from the viewpoint of providing excellent polishing rate and polishing uniformity. Note that, in a cross section shape taken in a direction perpendicular to the tangential direction of the annular grooves or the spiral groove, the width of the spiral groove or the concentric grooves is defined as follows. When the cross-sectional shape is rectangular or square, the width of the spiral groove or the concentric grooves is defined as the width of the polishing surface. When the cross-sectional shape is

trapezoidal or inverse trapezoidal, the width of the spiral groove or the concentric grooves is defined as an average width of the lower base. When a tapered portion resulting from chamfering is formed as in the case of a Y-shape, the width of the spiral groove or the concentric grooves is defined as the width of a groove cross section of the polishing surface assuming that no tapered portions are formed. When the cross-sectional shape is triangular, semi-circular, or semi-oval, the width of the spiral groove or the concentric grooves is defined as the width at a position of 1/2 of the depth.

As for the depth of the spiral groove or the concentric grooves, an average depth of the deepest portions of the spiral groove or the concentric grooves is preferably 0.3 to 3.0 mm, and more preferably about 0.5 to 2.5 mm from the viewpoint of ensuring supply to sufficiently deliver the slurry to the polishing region, and suppressing deformation of the polishing pad to stabilize the polishing performance. When the spiral groove or the concentric grooves are too deep, the volume of the spiral groove or the concentric grooves tends to be large, and a larger amount of the slurry needs to be supplied in order to sufficiently deliver the slurry throughout the polishing region during polishing, which may be not preferable in terms of costs. When the spiral groove or the concentric grooves are too shallow, the volume of the spiral groove or the concentric grooves tends to be small, and the amount of the slurry retained in the polishing region during polishing is reduced to reduce the amount of the slurry supplied to the land area of the polishing region, and thus the polishing rate tends to be reduced.

As for the cross-sectional area of the spiral groove or the concentric grooves, as shown in FIG. 3A, a cross-sectional area Sb ($mm^2$), which is an average cross-sectional area of cross sections in a direction perpendicular to the tangential direction, is preferably 0.2 to 4.5 $mm^2$, and more preferably 0.3 to 4.0 $mm^2$ from the viewpoint of ensuring a sufficient amount of the slurry supplied to the polishing region. When the cross-sectional area Sb is too large, a larger amount of the slurry needs to be added dropwise in order to sufficiently deliver the slurry throughout the polishing region, which may not be preferable in terms of costs. When the cross-sectional area Sb is too small, the amount of the slurry supplied to the polishing region is reduced, and thus the polishing rate tends to be reduced. Note that the average cross-sectional area is also the average cross-sectional area of the grooves.

Note that the groove pitch P, the groove width Wb, the depth, the cross-sectional area Sb and so forth of the spiral groove or the concentric grooves are defined based on those of an unused polishing pad before break-in treatment.

As described above, the polishing pad according to the present embodiment includes radial grooves including at least two line segment-shaped grooves extending from the central region to the peripheral edge region of the polishing surface. Also, each of the line segment-shaped grooves has a first end portion in a region at a distance of 5 to 10% of the radius of the polishing surface from the center of the radial grooves. In addition, each of the line segment-shaped grooves has a second end portion in a region at a distance of 35 to 70% of the radius of the polishing surface from the center of the radial grooves. Here, a "center of the radial grooves" refers to a position of the center of gravity of the first end portions of all of the line segment-shaped grooves. Also, the line segment-shaped grooves have an average length of 30 to 65% of the radius of the polishing surface. Such line segment-shaped grooves form intersection portions with the spiral groove or the concentric grooves in the polishing surface.

Note that a "distance of 5% of the radius of the polishing surface from the center of the radial grooves" refers to a distance corresponding to a length of 5% of the radius of the polishing surface from the center of the radial grooves. Similarly, a "distance of 10% of the radius of the polishing surface from the center of the radial grooves" refers to a distance corresponding to a length of 10% of the radius of the polishing surface from the center of the radial grooves.

Referring to FIG. 1, in the polishing pad 10, the line segment-shaped grooves S1 to S8 formed on the polishing surface each have a first end portion E1 in a region at a distance of 5 to 10% of the radius of the polishing surface from the center G of the radial grooves that coincides with the center of the spiral groove H. In addition, the line segment-shaped grooves S1 to S8 each have a second end portion E2 in a region at a distance of 35 to 70% of the radius of the polishing surface from the center G of the radial grooves that coincides with the center of the spiral groove H. Also, the line segment-shaped grooves S1 to S8 have an average length of 30 to 65% of the radius of the polishing surface. Referring to FIG. 2, in the polishing pad 20 as well, each of the line segment-shaped grooves S1 to S8 formed on the polishing surface has a first end portion E1 in a region at a distance of 5 to 10% of the radius of the polishing surface from the center G of the radial grooves that coincides with the center of the concentric annular grooves C1 to C11. In addition, the line segment-shaped grooves S1 to S8 each have a second end portion E2 in a region at a distance of 35 to 70% of the radius of the polishing surface from the center G of the radial grooves that coincides with the center of the concentric grooves. Also, the line segment-shaped grooves S1 to S8 have an average length of 30 to 65% of the radius of the polishing surface.

That is, in the polishing pad 10 or the polishing pad 20 according to the present embodiment, each of the eight line segment-shaped grooves S1 to S8 has a first end portion E1 disposed along a virtual circle K1 indicating a position corresponding to about 7% of the radius of the polishing surface from the center G of the radial grooves, and has a second end portion E2 disposed along a virtual circle K2 indicating a position corresponding to about 52.5% of the radius of the polishing surface from the center G of the radial grooves. Also, the eight line segment-shaped grooves S1 to S8 have an average length of about 45.5% of the radius of the polishing surface.

As a result of the first end portions serving as the start points of the line segment-shaped grooves being located in a region at a distance of 5 to 10% of the radius of the polishing surface from the center of the radial grooves in this manner,

the slurry that has been added dropwise to the polishing surface enters the line segment-shaped grooves at an appropriate timing, thus easily allowing the slurry to be uniformly distributed in the polishing region.

When the first end portions are present in a region at a distance of less than 5% of the radius of the polishing surface from the center of the radial grooves, the slurry that has been accumulated in the vicinity of the central region of the polishing surface is likely to enter the line segment-shaped grooves preferentially over the spiral groove or the concentric grooves, and thus the amount of the slurry supplied in the vicinity of the central region becomes nonuniform, resulting in a reduced polishing rate. When the first end portions serving as the start points of the line segment-shaped grooves are present in a region at a distance of greater than 10% of the radius of the polishing surface from the center of the radial groove, the slurry that has been accumulated in the vicinity of the central region is less likely to enter the line segment-shaped grooves, and thus the amount of the slurry supplied to the polishing region tends to be reduced.

On the other hand, the second end portions serving as the end points of the line segment-shaped grooves are formed so as to be present in a region at a distance of 35 to 70% of the radius of the polishing surface from the center of the radial grooves. As a result of the second end portions serving as the end points of the line segment-shaped grooves being present in a region at a distance of 35 to 70% of the radius of the polishing surface from the center of the radial groove, the slurry that has entered the line segment-shaped grooves from the vicinity of the central region is appropriately fed to the polishing region, but not to the vicinity of the peripheral edge region of the polishing surface. Accordingly, the slurry is less likely to leak out of the system from the peripheral edge of the polishing surface, and thus a sufficient amount of the slurry can be easily retained in the polishing region. More preferably, the second end portions of the line segment-shaped grooves are located in a region at a distance of 40 to 65% of the radius of the polishing surface from the center of the radial grooves.

When the second end portions of the line segment-shaped grooves are present in a region at a distance of less than 35% of the radius of the polishing surface from the center of the radial grooves, the length of the line segment-shaped grooves is too short, and thus the slurry that has entered the line segment-shaped groove is less likely to be sufficiently delivered to the polishing region. This leads to an insufficient supply of the slurry in the polishing region, resulting in a reduced polishing rate. When the second end portions of the line segment-shaped grooves are located in a region at a distance of greater than 70% of the radius of the polishing surface from the center of the radial grooves, an excessive amount of the slurry is supplied to the vicinity of the peripheral edge region of the polishing surface. Accordingly, the slurry leaks out of the system from the peripheral edge, and is likely to be wasted. This results in nonuniform distribution of the slurry in the polishing region, thus reducing the polishing rate.

Such line segment-shaped grooves constituting the radial grooves have an average length of 30 to 65%, preferably 35 to 60% to the radius of the polishing surface. When the ratio of the average length of the line segment-shaped grooves to the radius of the polishing surface is less than 30%, the slurry that has entered the line segment-shaped grooves is less likely to be sufficiently delivered to the polishing region. This leads to insufficient supply of the slurry in the polishing region, resulting in a reduced polishing rate. When the ratio of the average length of the line segment-shaped grooves to the radius of the polishing surface is greater than 65%, an excessive amount of the slurry is supplied to the vicinity of the peripheral edge region of the polishing surface, and thus the slurry leaks out of the system from the peripheral edge, and is likely to be wasted. Note that the average length of the line segment-shaped grooves is also an average of the lengths of the line segment-shaped grooves.

The number of line segment-shaped grooves constituting the radial grooves is not particularly limited, as long as the number is two or more. However, the number is preferably 4 to 24, and more preferably 5 to 16, since the slurry retention in the polishing region is improved due to excellent balance between slurry supply and discharge. When the number of line segment-shaped grooves is too small, the supply of the slurry to the polishing region is likely to be insufficient. When the number of line segment-shaped grooves is too large, the discharge to the polishing surface is increased, and thus the amount of the slurry supplied by one line segment-shaped groove becomes insufficient. Accordingly, the supply of the slurry to the polishing region tends to vary.

The line segment-shaped grooves may be either linear or curved, but is preferably linear from the viewpoint of ease of controlling the supply amount or the discharge amount of the slurry.

The cross-sectional shape of the line segment-shaped grooves is also not particularly limited. Specifically, a quadrangular shape such as a rectangular shape, a square shape, a trapezoidal shape, or an inverse trapezoidal shape, a triangular shape, a semi-circular shape, a semi-oval shape and so forth can be used as the shape of a cross section of the line segment-shaped groove in a direction perpendicular to the length direction thereof, without any particular limitation. Among these, a quadrangular shape is preferable because of the excellent processability, slurry retention, and supply stability.

The line segment-shaped grooves also preferably have a cross section inclined such that the groove or grooves are reverse-tapered toward an opening thereof in order to suppress generation of burrs during polishing. Specifically, it is preferable that the cross section is a so-called Y-shaped cross section having tapered portions formed by chamfering two corners forming a quadrangular grove located on the polishing surface such that the corners are inclined at a predetermined angle $\beta$, or an inverse trapezoidal cross section formed such that oblique sides are inclined at a predetermined

angle β to two corners forming a base angle. Such an inclination angle is not particularly limited, but is preferably 20 degrees to less than 90 degrees, more preferably 25 to 80 degrees, and particularly preferably 30 to 75 degrees. In particular, when the angle is 30 to 80 degrees, burrs, which are likely to be generated at corner portions of each groove during polishing can be more easily suppressed, and thus a reduction in the polishing rate and a reduction in the polishing uniformity can be easily suppressed.

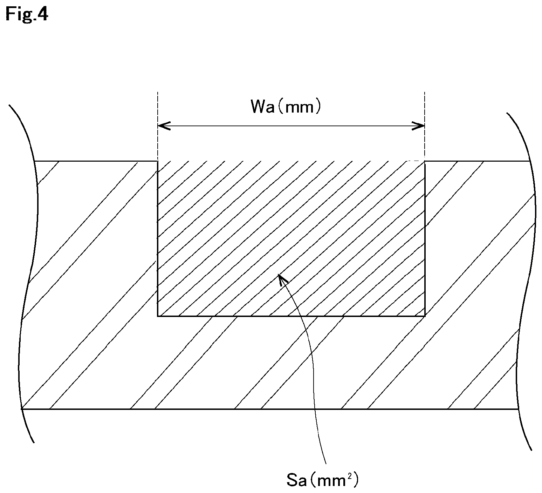

Referring to FIG. 4, as for the widths of the line segment-shaped grooves, a groove width Wa (mm), which is an average width of the line segment-shaped grooves is preferably 0.1 to 10 mm, and more preferably 0.2 to 5 mm, from the viewpoint of achieving a good balance between the area of the radial grooves and the area of the land area. Note that the width of each line segment-shaped groove is defined in a cross-sectional shape cut along a direction perpendicular to the length direction in the same manner as in the case of the width of the spiral groove or the concentric grooves.

As for the depths of the line segment-shaped grooves, an average depth of the deepest portions of the line segment-shaped grooves is preferably 0.3 to 3.0 mm, and more preferably about 0.5 to 2.5 mm, from the viewpoint of sufficiently ensure supply to sufficiently deliver the slurry to the polishing region, and suppress the deformation of the polishing pad to stabilize the polishing performance. When the line segment-shaped grooves are too deep, the volume of the line segment-shaped grooves tends to be increased, and thus a larger amount of the slurry needs to be added dropwise to the polishing region in order to sufficiently deliver the slurry throughout the polishing region during polishing, and thus may not be preferable in terms of costs. When the line segment-shaped grooves are too shallow, the volume of the line segment-shaped grooves tends to be decreased, and thus the slurry tends to be less likely to be sufficiently delivered to the polishing region due to an overflow of the slurry to the land area of the central region during polishing. When the line segment-shaped grooves are too shallow, continued use of the polishing pad makes the line segment-shaped grooves shallower due to wear of the polishing surface, and there is also a tendency that the effect of increasing the polishing rate becomes less sustainable.

As shown in FIG. 4, when an average cross-sectional area of cross sections in a direction perpendicular to the length direction is defined as a cross-sectional area Sa ($mm^2$), the cross-sectional area of the line segment-shaped grooves is preferably 0.3 to 4.5 $mm^2$, and more preferably 0.5 to 4.0 $mm^2$, from the viewpoint of ensuring slurry supply to the polishing region. When the average of the cross-sectional areas of the line segment-shaped grooves is too large, a larger amount of the slurry needs to be added dropwise to the polishing surface in order to sufficiently deliver the slurry throughout the polishing region of the polishing surface, and thus may not be preferable in terms of costs. When the average of the cross-sectional areas of the line segment-shaped grooves is too small, the slurry is likely to overflow to the land area of the central region before distributing the slurry to the polishing region during polishing, and there is a tendency that the slurry is less likely to be sufficiently delivered throughout the polishing region of the polishing surface. Note that the average cross-sectional area of the line segment-shaped grooves is also an average of the cross-sectional areas of the line segment-shaped grooves.

Note that the depth, the groove width Wa, the cross-sectional area Sa and so forth of the line segment-shaped grooves are also defined based on those of an unused polishing pad before break-in treatment.

In such a polishing pad according to the present embodiment, intersection portions between the line segment-shaped grooves and the spiral groove or the concentric grooves are present within a region corresponding to 5 to 70% of the radius of the polishing surface from the center of the radial grooves.

Referring to FIG. 1, on the polishing surface of the polishing layer 1 of the polishing pad 10, a spiral groove H having a uniform groove pitch P and a number of turns of 10 are formed in a region corresponding to 4.5 to 100% of the radius of the polishing surface from the spiral center. Also, the sections of the spiral groove H that correspond to the first to six turns of the spiral groove H intersect the line segment-shaped grooves S1 to S8 to form 41 intersection portions. The intersection portions are preset within a region corresponding to about 7 to 52.5% of the radius, the region being surrounded by a virtual circle K1 indicating a position corresponding to about 7% of the radius of the polishing surface from the center of the spiral groove H, and a virtual circle K2 indicating a position corresponding to about 52.5% of the radius of the polishing surface from the center of the spiral groove H.

Similar, referring to FIG. 2, on the polishing surface of the polishing layer 21 of the polishing pad 20, the concentric annular grooves C1 to C11 having a uniform groove pitch P are formed in at least a region corresponding to 5 to 90% of the radius of the polishing surface from the center of the concentric circles. Also, each of the line segment-shaped grooves S1 to S8 intersects the annular grooves C2 to C6 to form 40 intersection portions. The intersection portions are present within a region at a distance of about 7 to 52.5% of the radius of the polishing surface, the region being surrounded by a virtual circle K1 indicating a position at a distance of about 7% of the radius of the polishing surface from the center G of the concentric grooves, and a virtual circle K2 indicating a position at a distance of about 52.5% of the radius of the polishing surface from the center of the spiral groove H.

In this manner, as a result of causing the intersection portions between the line segment-shaped grooves and the spiral groove or the concentric grooves to be present within in a region at a distance of 5 to 70% of the radius of the polishing surface from the center of the radial grooves, the slurry that has entered the line segment-shaped grooves can be swiftly supplied to the polishing region and be easily retained therein. When the intersection portions are present in a region at a

distance of greater than 70% of the radius of the polishing surface from the center of the radial grooves, the slurry is excessively delivered to the vicinity of the peripheral edge region of the polishing surface during polishing, and thus the slurry is likely to leak out of the system from the peripheral edge of the polishing surface. Consequently, the amount of the slurry retained in the polishing region is reduced, resulting in a reduced polishing rate. When the intersection portions are present in a region at a distance of less than 5% of the radius of the polishing surface from the center of the radial grooves, the slurry that has been added dropwise to the polishing surface is directly added dropwise to the line segment-shaped grooves, and is likely to splash off therefrom. Accordingly, the supply is likely to vary in the polishing surface.

In the polishing pad according to the present embodiment, a cross-sectional area Sa ($mm^2$), which is an average cross-sectional area of cross sections of the line segment-shaped grooves in a direction perpendicular to the length direction thereof, and a cross-sectional area Sb ($mm^2$), which is an average cross-sectional area of a cross section or cross sections of the spiral groove or the concentric grooves in a direction perpendicular to the tangential direction thereof, satisfy $0.1 \leq Sb/Sa < 1.0$, preferably $0.15 \leq Sb/Sa \leq 0.85$. FIG. 3A shows a cross-sectional area Sb of a cross section in a direction perpendicular to the tangential direction of the spiral groove or the concentric grooves, and FIG. 4 shows a cross-sectional area Sa of a cross section in a direction perpendicular to the length direction of the line segment-shaped grooves.

When Sb/Sa, which is the ratio of the cross-sectional area Sb of the spiral groove or the concentric grooves to the cross-sectional area Sa of the line segment-shaped grooves is 1.0 or more, the slurry easily flows to the spiral groove or the concentric grooves, and thus supply of the slurry to the polishing region is reduced, resulting in a reduced polishing rate. When Sb/Sa is less than 0.1, the slurry flows to the line segment-shaped grooves too preferentially, and thus the slurry tends to overflow to the land area located in the vicinity of the central region of the polishing surface, resulting in a reduction in supply of the slurry to the polishing region.

It is preferable that Sb/Sa is preferably $0.25 \leq Sb/Sa \leq 0.85$, and more preferably $0.44 \leq Sb/Sa \leq 0.80$, from the viewpoint of achieving a higher polishing rate, and additionally providing excellent polishing uniformity in the surface to be polished of the material to be polished.

In the polishing pad according to the present embodiment, a groove width Wa (mm), which is an average width of the line segment-shaped grooves, is preferably larger than a groove width Wb (mm), which is an average width of the spiral groove or the concentric grooves. Specifically, it is preferable that Wa and Wb satisfy preferably $0.1 \leq Wb/Wa < 1.0$, more preferably $0.1 \leq Wb/Wa \leq 0.9$, and particularly preferably $0.1 \leq Wb/Wa \leq 0.6$ since supply of the slurry to the polishing region tends to be improved as a result of the slurry swiftly flowing to the line segment-shaped grooves. When Wb/Wa, which is the ratio of the groove width Wb to the groove width Wa, is too high, the slurry is likely to flow to the spiral groove or the concentric grooves, and thus supply of the slurry to the polishing region tends to be reduced. When Wb/Wa is too low, the slurry flows to the line segment-shaped grooves too preferentially, and thus the slurry overflows to the land area in the vicinity of the central region of the polishing surface, resulting in a reduction in supply of the slurry to the polishing region.

In the polishing pad according to the present embodiment, a groove width Wb (mm), which is an average width of the spiral groove or the concentric grooves, and a groove pitch P (mm) satisfy preferably $0.02 \leq Wb/P \leq 0.25$, and more preferably $0.025 \leq Wb/P \leq 0.16$. When the average of the widths of the spiral groove or the concentric grooves relative to the groove pitch P (mm) is too large, the polishing surface that comes into contact with the material to be polished becomes too small, and thus the polishing efficiency tends to be reduced. When the aforementioned average is too small, the slurry supplied through the grooves tends to be insufficient on the polishing surface.

In the polishing pad according to the present embodiment, a groove width Wa (mm), which is an average width of the line segment-shaped grooves, a groove width Wb (mm), which is an average width of the spiral groove or the concentric grooves, and an average groove pitch P (mm) of the spiral groove or the concentric grooves satisfy preferably $0.20 \leq \{Wb^2/(P \times Wa)\} \times 100 \leq 25$, more preferably $0.25 \leq \{Wb^2/(P \times Wa)\} \times 10\ 0 \leq 15$, and particularly preferably $0.25 \leq \{Wb^2/(P \times Wa)\} \times 100 \leq 10$. When $\{Wb^2/(P \times Wa)\} \times 100$ is too large, the slurry flow to the spiral groove or the concentric grooves too preferentially, resulting in a reduction in supply of the slurry to the polishing region. When $\{Wb^2/(P \times Wa)\} \times 100$ is too small, the slurry enters the line segment-shaped grooves preferentially, and thus the slurry tends to overflow to the land area in the vicinity of the central region of the polishing surface, resulting in a reduction in supply of the slurry to the polishing region.

As the material for forming the polishing layer included in the polishing pad according to the present embodiment, any synthetic or natural polymer material conventionally used for production of polishing layers of polishing pads may be used without any particular limitation. Specific examples of the polymer material for forming the polishing layer include polyurethane, polyethylene, polypropylene, polybutadiene, an ethylene-vinyl acetate copolymer, a butyral resin, polystyrene, polyvinyl chloride, an acrylic resin, an epoxy resin, polyester, and polyamide. These may be used alone or in a combination of two or more. Among these, the polymer materials composed mainly of polyurethane are particularly preferable from the viewpoint of achieving a polishing layer that has excellent planarization performance and is resistant to scratching. In the following, a polyurethane used as a material for forming the polishing layer will be described in detail as a representative example.

A polyurethane can be obtained by reacting a polyurethane raw material containing a polymer diol, an organic diisocyanate, and a chain extender. Examples of the polymer diol, the organic diisocyanate, and the chain extender

constituting the polyurethane raw material include the following compounds.

Specific examples of the polymer diol include polyether diols such as polyethylene glycol and polytetramethylene glycol; polyester diols such as poly(nonamethylene adipate)diol, poly(2-methyl-1,8-octamethylene adipate)diol, and poly(3-methyl-1,5-pentamethylene adipate)diol; and polycarbonate diols such as poly(hexamethylene carbonate)diol and poly(3-methyl-1,5-pentamethylene carbonate)diol. These may be used alone or in a combination of two or more.

Specific examples of the organic diisocyanate include aliphatic or alicyclic diisocyanates such as hexamethylene diisocyanate, isophorone diisocyanate, 4,4'-dicyclohexylmethane diisocyanate, and 1,4-bis(isocyanatomethyl)cyclohexane; and aromatic diisocyanates such as 4,4'-diphenylmethane diisocyanate, 2,4-tolylene diisocyanate, 2,6-tolylene diisocyanate, and 1,5-naphthylene diisocyanate. These may be used alone or in a combination of two or more. Among these, 4,4'-diphenylmethane diisocyanate is preferable, for example, because the resulting polishing layer has excellent abrasion resistance.

Examples of the chain extender include low-molecular weight compounds including, in the molecule, two or more active hydrogen atoms capable of reacting with an isocyanate group, and having a molecular weight of 350 or less. Specific examples thereof include diols such as ethylene glycol, diethylene glycol, 1,3-propanediol, 1,2-butanediol, 1,3-butanediol, 1,4-butanediol, 1,5-pentanediol, neopentyl glycol, 1,6-hexanediol, 3-methyl-1,5-pentanediol, 1,4-bis(β-hydroxyethoxy) benzene, 1,9-nonanediol, cis-2-butene-1,4-diol, and spiroglycol; and diamines such as ethylenediamine, tetramethylene diamine, hexamethylene diamine, nonamethylene diamine, hydrazine, xylylene diamine, isophoronediamine, and piperazine. These may be used alone or in a combination of two or more. Among these, it is particularly preferable to include at least one selected from 1,4-butanediol, cis-2-butene-1,4-diol, 1,5-pentanediol, and 1,9-nonanediol.

The mixing ratios of the components of the polyurethane raw material are adjusted as appropriate in consideration of the properties to be imparted to the polishing layer. For example, the components are preferably mixed at such a ratio that the isocyanate group contained in the organic polyisocyanate is preferably 0.95 to 1.3 moles, more preferably 0.96 to 1.1 moles, and particularly preferably 0.97 to 1.05 moles, per mole of the active hydrogen atoms contained in the polymer diol and the chain extender. When the amount of the isocyanate group contained in the organic diisocyanate is too small, the mechanical strength and the abrasion resistance of the resulting polyurethane tend to be reduced. When the amount of the isocyanate group contained in the organic diisocyanate is too large, the productivity of the polyurethane and the storage stability of the polyurethane raw material tend to be reduced.

The ratio of nitrogen atoms derived from the isocyanate group of the organic polyisocyanate in the polyurethane is preferably 4.8 to 7.5 mass%, more preferably 5.0 to 7.3 mass%, and particularly preferably 5.2 to 7.1 mass%, because a polishing layer particularly excellent in planarization performance and scratch resistance can be obtained. When the ratio of the nitrogen atoms derived from the isocyanate group is too low, the hardness of the resulting polishing layer tends to be reduced.

It is preferable that the polyurethane used as the material for forming the polishing layer is a thermoplastic polyurethane, because a polishing layer having a high hardness and exhibiting excellent planarization performance can be obtained. Note that "thermoplasticity" refers to the properties of being moldable through melting by a heating process such as extrusion molding, injection molding, calendering, and 3D-printer molding. Such a thermoplastic polyurethane is obtained by a known polyurethane manufacturing method such as a prepolymer method or a one-shot method, using the polyurethane raw material containing the polymer diol, the organic diisocyanate, and the chain extender. In particular, a method in which melt-polymerization is performed by melt-kneading the polyurethane raw material substantially in the absence of a solvent, and a method in which continuous melt-polymerization is performed using a multi-screw extruder are preferable because of the excellent productivity.

The polishing layer preferably has an unfoamed structure (non-porous). The polishing layer with an unfoamed structure is preferable in that the polishing layer can retain a high hardness, thus exhibiting further excellent planarization performance. Also, the polishing layer with an unfoamed structure is preferable in that no pores are exposed on the surface of the polishing layer, and the abrasive grains contained in a slurry do not agglomerate or agglutinate in the pores, so that scratches are less likely to be generated. In addition, the polishing layer with an unfoamed structure is preferable in that the polishing layer has a lower ware rate than that of a polishing layer with a foam structure, and therefore has a longer life.

Although the manufacturing method of the polishing layer is not particularly limited, for example, a polymer material composition for polishing layers, which is a composition obtained by mixing, into a polymer material for forming the above-described polishing layer, conventionally used additives and the like for polishing layers, is formed into a sheet by a known sheeting method. Specific examples thereof include a method in which the polymer material composition for polishing layers is formed into a sheet by melt-extruding the material composition using an extruder such as a single-screw extruder or twin-screw extruder equipped with a T-die. Also, the sheet may be manufactured by molding the above-described material composition for polishing layers into a block shape, and slicing the block-shaped molded body. The composition of the polymer material composition for polishing layers is not particularly limited. Specifically, the polymer material composition contains the polymer material at a content ratio of preferably 50 mass % or more, more preferably 80 mass% or more, particularly preferably 90 mass% or more, and quite particularly preferably 99 mass% or more. That is, when the polymer material composition contains any additive, the content ratio of the additive is preferably 50 mass% or

less, more preferably 20 mass% or less, particularly preferably 10 mass % or less, and quite particularly preferably 1 mass% or less.

The thickness of the obtained sheet is adjusted to a desired thickness through griding or the like, and the sheet is formed into a circular shape by through cutting, punching, machining, or the like, whereby a polishing layer sheet is obtained. Then, using one surface of the circular polishing layer sheet as a polishing surface, the above-described radial grooves including at least two line segment-shaped grooves extending from the central region of the polishing surface toward the peripheral edge region, and the above-described spiral groove or concentric grooves formed spanning from the central region to the peripheral edge region are provided, thus obtaining a polishing layer used for the polishing pad according to the present embodiment.

Such a polishing layer, for example, a polishing layer containing a thermoplastic polyurethane with an unfoamed structure, has a density of preferably 1.0 g/cm$^3$ or more, more preferably 1.1 g/cm$^3$ or more, and particularly preferably 1.2 g/cm$^3$ or more. When the density of the polishing layer containing the thermoplastic polyurethane with an unfoamed structure is too low, the polishing layer tends to become too soft, so that the polishing rate and the polishing uniformity tend to be reduced.

The D hardness of the polishing layer is preferably 45 to 90, more preferably 50 to 88, particularly preferably 55 to 87, and quite particularly preferably 60 to 86, from the viewpoint of excellent polishing uniformity due to high planarization performance, and also excellent suppression of generation of surface scratches of the surface to be polished of the material to be polished.

The method of forming the radial grooves, the spiral groove, or the concentric grooves provided on the polishing surface is not particularly limited. Specific examples thereof include a method in which the grooves are formed by machining one surface of the polishing layer sheet; a method in which the grooves are formed by melting or volatilizing a polymer through transferring by which a heated mold or metal wire is brought into contact with one surface of the polishing layer sheet through stamping; and a method in which a polishing layer sheet that includes a polishing surface having the grooves is molded using a mold on which protrusions for forming the grooves have been formed in advance. Among these, the method involving machining or the method involving transferring are preferable from the viewpoint of excellent productivity, and the method involving machining is particularly preferable from the viewpoint of excellent machining accuracy. The thickness of the polishing layer is preferably about 0.4 to 5.0 mm, and more preferably about 0.6 to 4.5 mm.

In the above-described manner, the polishing layer included in the polishing pad is manufactured. The polishing pad according to the present embodiment may directly use the polishing layer manufactured in this manner as a single-layer polishing pad, or may use a polishing pad having a layered structure including two or more layers, obtained by stacking another layer such as a cushioning layer or a support layer on a surface opposite to the polishing surface.

FIG. 5 is a schematic partial side view of the polishing pad 10 and the polishing pad 20. Referring to FIG. 5, in the polishing pad 10 and the polishing pad 20, the cushioning layer 7 is stacked on the surface opposite to the polishing surface F of the polishing layer 1 or the polishing layer 11 with the adhesion layer 6 interposed therebetween. A polishing pad having a layered structure in which a cushioning layer is stacked is particularly preferable in that the polishing uniformity in the whole plane can be easily improved. When the polishing pad has a layered structure, a cushioning layer or a support layer is stacked on a surface opposite to the polishing surface of the polishing layer with a pressure-sensitive adhesive or an adhesive interposed therebetween.

The C hardness of the cushioning layer is preferably 20 to 70. Although the raw material of the cushioning layer is not particularly limited, examples thereof include a sheet obtained by impregnating a non-woven fabric with a resin, and a sheet of an elastomer with an unfoamed structure or a foam structure. Specific examples include sheets of composites obtained by impregnating a non-woven fabric with a polyurethane; rubbers such as natural rubber, nitrile rubber, polybutadiene rubber and silicone rubber; thermoplastic elastomers such as a polyester-based thermoplastic elastomer, a polyamide-based thermoplastic elastomer and a fluorine-based thermoplastic elastomer; foamed plastics; and polyurethanes. Among these, a sheet of a polyurethane having a foam structure is particularly preferable because desirable flexibility can be easily obtained.

The polishing pad according to the present embodiment described above can be preferably used for CMP. Next, an embodiment of CMP for which the polishing pad 10 of the present embodiment is used will be described.

In CMP, a CMP apparatus 100 including a circular rotary platen 101, a slurry supply nozzle 102, a carrier 103, and a pad conditioner 104 as shown in FIG. 6 is used, for example. The polishing pad 10 is attached to the surface of the rotary platen 101 by means of a double-sided pressure-sensitive adhesive sheet or the like. In addition, the carrier 103 supports a base material 50 to be polished, which is an object to be polished.

In the CMP apparatus 100, the rotary platen 101 is rotated by a motor (not shown) in the direction indicated by the arrow, for example. The carrier 103 is rotated by a motor (not shown) in the direction indicated by the arrow, for example, while bringing a surface to be polished of the material 50 to be polished into pressure contact with the polishing surface of the polishing pad 10. The pad conditioner 104 is rotated in the direction indicated by the arrow, for example. When the diameter of the pad conditioner 104 is smaller than the diameter of the material 50 to be polished, the pad conditioner 104 is oscillated in the radial direction of the rotary platen 101 in order to roughen, to a roughness suitable for polishing, the entire

region of the polishing pad that comes into contact with the material to be polished.

When an unused polishing pad is used, conditioning called break-in for forming a roughness suitable for polishing by finely roughening the polishing surface of the polishing pad is usually performed prior to polishing the material to be polished. Specifically, while pouring water onto the surface of the polishing pad 10 that is fixed to the rotary platen 101 and is being rotated, the pad conditioner 104 for CMP is pressed against the surface of the polishing pad 10 so as to condition the surface. As the pad conditioner, it is possible to use, for example, a pad conditioner in which diamond particles are fixed onto the surface of a carrier by electrodeposition of nickel or the like.

Then, after completion of break-in, the polishing of the surface to be polished of the material to be polished is started. In polishing, the slurry is supplied from the slurry supply nozzle to the surface of the rotating polishing pad. The slurry contains, for example, a liquid medium such as water or oil; an abrasive such as silica, alumina, cerium oxide, zirconium oxide, or silicon carbide; a base; an acid; a surfactant; an oxidizing agent; a reducing agent; and a chelating agent. When performing CMP, a lubricating oil, a coolant, and the like may be used as needed in combination with the slurry. Then, the material to be polished that is fixed to the carrier and is rotated is pressed against the polishing pad on which the slurry is evenly delivered onto the polishing surface. Then, the polishing treatment is continued until a predetermined flatness or polishing amount is achieved. Adjustment of the pressing force applied during polishing or the speed of relative movement between the rotary platen and the carrier affects the finishing quality.

The polishing conditions are not particularly limited; however, the rotational speed of each of the platen and the material to be polished is preferably as low as 300 rpm or less in order to efficiently perform polishing, and the pressure applied to the material to be polished in order for the material to be polished in pressure contact with the polishing pad is preferably 150 kPa or less from the viewpoint of preventing a flaw from being caused after polishing. During polishing, it is preferable that the slurry is continuously or discontinuously supplied to the polishing pad such that the slurry is evenly delivered onto the polishing surface.

Then, after the material to be polished that has undergone polishing is fully washed, the material is dried by removing water droplets attached thereto by using a spin drier or the like. In this manner, the surface to be polished becomes a smooth surface.

Such CMP according to the present embodiment can be preferably used for polishing performed during the manufacturing process of various semiconductor devices, micro electro mechanical systems (MEMS), and the like. Examples of the material to be polished include semiconductor base materials such as silicon, silicon carbide, gallium nitride, gallium arsenic, zinc oxide, sapphire, germanium, and diamond; wiring materials, including, for example, an insulating film such as a silicon oxide film, a silicon nitride film, or a low-k film formed on a wiring board having predetermined wiring, and copper, aluminum, and tungsten; glass, crystal, an optical base material, and a hard disk. In particular, the polishing pad according to the present embodiment is preferably used for polishing insulating films and wiring materials formed on semiconductor base materials.

[EXAMPLES]

Hereinafter, the present invention will be described in further detail by way of examples. It should be appreciated that the scope of the invention is by no means limited to the examples but defined by the appended claims.

[Production Example 1]

Polytetramethylene glycol [abbreviation: PTMG] having a number-average molecular weight of 850, polyethylene glycol [abbreviation: PEG] having a number-average molecular weight of 600, 1,4-butanediol [abbreviation: BD], and 4,4'-diphenylmethane diisocyanate [abbreviation: MDI] were blended at a mass ratio of PTMG:PEG:BD:MDI of 24.6:11.6:13.8:50.0, and the resulting blend was continuously supplied to a coaxially rotating twin-screw extruder using a metering pump, and was subjected to continuous melt-polymerization, to give a thermoplastic polyurethane. Then, the polymerized thermoplastic polyurethane melt was continuously extruded in the form of a strand into water, and subsequently finely cut into pellets using a pelletizer. The pellets were dried through dehumidification for 20 hours at 70°C, subsequently supplied to a single-screw extruder, and extruded from a T-die, to mold a sheet. Then, after the surface of the obtained sheet had been ground to give a sheet having a uniform thickness of 2.0 mm, the sheet was cut into a circular shape having a diameter of 740 mm, to give a polishing layer sheet, which was a non-foam. The D hardness of the polishing layer sheet, as measured at a measurement temperature of 25°C in accordance with JIS K 7311, was 62.

[Production Example 2]

Pellets of a thermoplastic polyurethane were obtained in the same manner as in Production Example 1 except that a polyurethane raw material obtained by blending polytetramethylene glycol having a number-average molecular weight of 850, 3-methyl-1,5-pentanediol [abbreviation: MPD], 1,4-butanediol, and 4,4'-diphenylmethane diisocyanate at a

mass ratio of PTMG:MPD:BD:MDI of 12.5:5.7:17.5:64.3 was used in place of the polyurethane raw material obtained by blending PTMG, PEG, BD, and MDI at a mass ratio of PTMG:PEG:BD:MDI of 24.6:11.6:13.8:50.0 in Production Example 1. Then, a polishing layer sheet, which was a non-foam, was obtained in the same manner as in Production Example 1. The D hardness of the polishing layer sheet, as measured at a measurement temperature of 25°C in accordance with JIS K 7311, was 86.

[Production Example 3]

Pellets of a thermoplastic polyurethane were obtained in the same manner as in Production Example 1 except that a polyurethane raw material obtained by blending polytetramethylene glycol having number-average molecular weight of 850, polyethylene glycol [abbreviation: PEG] having a number-average molecular weight of 600, 1,9-nonanediol [abbreviation: ND], and 4,4'-diphenylmethane diisocyanate at a mass ratio of PTMG:PEG:ND:MDI of 32.2:5.7:19.6:42.5 was used in place of the polyurethane raw material obtained by blending PTMG, PEG, BD, and MDI at a mass ratio of PTMG:PEG:BD:MDI 24.6:11.6:13.8:50.0 in Production Example 1. Then, a polishing layer sheet, which was a non-foam, was obtained in the same manner as in Production Example 1. The D hardness of the polishing layer sheet, as measured at a measurement temperature of 25°C in accordance with JIS K 7311, was 56.

[Production Example 4]

Pellets of a thermoplastic polyurethane were obtained in the same manner as in Production Example 1 except that a polyurethane raw material obtained by blending polytetramethylene glycol having a number-average molecular weight of 850, polyethylene glycol having a number-average molecular weight of 600, 3-methyl-1,5-pentanediol [abbreviation: MPD], 1,9-nonanediol, and 4,4'-diphenylmethane diisocyanate at a mass ratio of PTMG:PEG:MPD:ND:MDI of 36.1:6.4:1.3:15.7:40.5 was used in place of the polyurethane raw material obtained by blending PTMG, PEG, BD, and MDI at a mass ratio of PTMG:PEG:BD:MDI of 24.6:11.6:13.8:50.0 in Production Example 1. Then, a polishing layer sheet, which was a non-foam, was obtained in the same manner as in Production Example 1. The D hardness of the polishing layer sheet, as measured at a measurement temperature of 25°C in accordance with JIS K 7311, was 46.

[Examples 1 to 25, and Comparative Examples 1 to 13]

Grooves having patterns of the shapes described in Tables 1 and 2 were formed through machining on a polishing surface constituting one surface of the polishing layer sheet having a D hardness of 62 obtained in Production Example 1.

In Example 12 and Comparative Example 4, concentric grooves were formed in which the center of the concentric circles was eccentric by 15 mm from the center of the polishing surface. At this time, the center of the concentric grooves is at a position away from the center of the polishing surface by a distance of about 4% of the radius. The center of the radial grooves in Example 13 coincided with the center of the concentric grooves.

The concentric grooves, the spiral groove, the grid-like groove, or the line segment-shaped grooves forming the radial grooves in each of the examples were chamfered as needed such that the inclined surface of each groove is inclined at an angle within a range of 35 to 80 degrees. The inclined surface of the inverse trapezoidal groove was also formed so as to be inclined at an angle within a range of 35 to 80 degrees. As a result of the angle of the inclined surface being changed, the cross-sectional area is changed.

The groove width and the groove cross-sectional area of each of the concentric grooves, the spiral groove, the grid-like groove, and the line segment-shaped grooves forming the radial grooves were measured based on cross sectional images obtained using a scanning electron microscope (SEM) at a magnification of 200X. Specifically, images of a cut surface of each of the polishing layers are captured at 18 evenly selected locations, and the widths of the grooves in the images were measured. Further, the cross-sectional areas were measured through image processing, and the average value thereof was obtained. The average groove pitch P of the concentric grooves, the spiral groove, or the grid-like groove was determined by measuring the pitches at 8 locations evenly selected from each of the regions of the polishing surface that came into contact with a silicon wafer, using a scale loupe, and obtaining an average thereof as an average groove pitch P. The depth of each groove was determined by measuring the depths at 8 locations evenly selected from each of the regions coming into contact with the silicon wafer, using a depth gauge "E-DP2J" manufactured by Nakamura Mfg. Co., Ltd., and averaging the measured values.

Then, a cushioning layer was attached to the back surface of the polishing layer as opposed to the polishing surface with a double-sided pressure-sensitive adhesive sheet, to form a multilayer polishing pad. As the cushioning layer, a "Poron H48" manufactured by INOAC Corporation, a foamed polyurethane sheet having a thickness of 0.8 mm, was used. Then, the polishing characteristics of the obtained polishing pad were evaluated by the following evaluation methods.

<Polishing Rate>

The obtained polishing pad was attached to a polishing apparatus "FREX-300" manufactured by EBARA CORPORATION. Then, a slurry obtained by diluting ten-fold a slurry "HS-8005" manufactured by Hitachi Chemical Co. was prepared, and a 12-inch-diameter silicon wafer having a silicon oxide film with a thickness of 2000 nm on the surface thereof was polished for 60 seconds at a platen rotation rate of 100 rpm, a head rotation rate of 99 rpm, and a polishing pressure of 30.0 kPa, while supplying the slurry onto the polishing surface of the polishing pad at a rate of 200 mL/min.

Then, using a pad conditioner (a diamond dresser (diamond grit: #100, blocky, metal base diameter: 19 cm) manufactured by A.L.M.T. Corp.), the surface of the polishing pad was conditioned for 30 seconds at a dresser rotation rate of 70 rpm, a polishing pad rotation rate of 100 rpm, and a dresser load of 20 N, while pouring pure water at a rate of 150 mL/min. Then, another silicon wafer was polished with the polishing pad, and the polishing pad was further conditioned for 30 seconds. Then, after being polished for 60 seconds, the polishing pad was conditioned for 30 seconds. Then, another silicon wafer was polished with the polishing pad, and the polishing pad was further conditioned for 30 seconds. In this manner, 10 silicon wafers were polished.

Then, the thicknesses before and after polishing of the silicon oxide film on the tenth silicon wafer that had been polished were measured at 49 points in the wafer plane, and the polishing rate (nm/min) at each of the points was determined. Specifically, the average value of the polishing rates at the 49 points was used as a polishing rate.

Then, based on a polishing rate of 1050 nm/min, which has been achievable using typical conventional groove shapes, the improvement rate of the polishing rate of each of the examples was calculated using the following equation:

$$\text{Improvement rate (\%) of polishing rate} = \text{Polishing rate} \div 1050 \times 100$$

The results are shown in Tables 1 and 2 below.

[Table 1]

| Example No. | Concentric grooves, spiral groove, or grid-like groove | | | | | | | | Radial grooves (line segment-shaped grooves) | | | | | | | | Sb/Sa | Wb/Wa | Wb²/(P*Wa)*100 [%] | Evaluation results | |
|---|---|---|---|---|---|---|---|---|---|---|---|---|---|---|---|---|---|---|---|---|---|
| | Shape | Ratio of formed region to radius from center of polishing surface (%) | Cross-sectional shape | Groove pitch P (mm) | Groove width Wb (mm) | Groove depth (mm) | Cross-sectional area Sb (mm²) | Wb/P | Number (grooves) | Cross-sectional shape | Groove width Wa (mm) | Groove depth (mm) | Ratio of distance from radial groove center to first end portion to radius of polishing surface (%) | Ratio of distance from radial groove center to second end portion to radius of polishing surface (%) | Ratio of groove length to radius (%) | Cross-sectional area Sa (mm²) | | | | Polishing rate [nm/min] | Polishing rate improvement rate (%) |
| Ex. 1 | Spiral | 4.5-100 | Inverse trapezoidal | 5.0 | 0.5 | 1.3 | 1.35 | 0.100 | 8 | Y-shaped | 2.0 | 1.3 | 5.4 | 54.0 | 48.6 | 2.76 | 0.49 | 0.25 | 2.50 | 1355 | 129 |
| Ex. 2 | Spiral | 4.5-100 | Y-shape | 7.5 | 0.2 | 1.3 | 1.46 | 0.027 | 8 | Y-shape | 0.5 | 1.5 | 5.4 | 54.0 | 48.6 | 3.16 | 0.46 | 0.40 | 1.07 | 1268 | 121 |

| | | | | | | | | | | | | | | | | | | | | | |
|---|---|---|---|---|---|---|---|---|---|---|---|---|---|---|---|---|---|---|---|---|---|
| Ex. 3 | Spiral | 4.5-100 | Y-shape | 6.0 | 1.3 | 1.0 | 1.55 | 0.217 | 8 | Y-shape | 1.4 | 1.2 | 5.4 | 54.0 | 48.6 | 1.93 | 0.80 | 0.93 | 20.12 | 1233 | 117 |
| Ex. 4 | Spiral | 4.5-100 | Y-shape | 7.0 | 0.5 | 1.3 | 1.86 | 0.071 | 8 | Y-shape | 2.0 | 1.5 | 5.4 | 54.0 | 48.6 | 4.21 | 0.44 | 0.25 | 1.79 | 1265 | 120 |
| Ex. 5 | Spiral | 4.5-100 | Y-shape | 3.5 | 0.5 | 1.3 | 1.07 | 0.143 | 8 | Y-shape | 2.0 | 1.3 | 5.4 | 54.0 | 48.6 | 2.76 | 0.39 | 0.25 | 3.57 | 1242 | 118 |
| Ex. 6 | Spiral | 4.5-100 | Y-shape | 6.0 | 0.7 | 1.3 | 1.07 | 0.117 | 8 | Y-shape | 2.0 | 1.3 | 5.4 | 54.0 | 48.6 | 3.81 | 0.28 | 0.35 | 4.08 | 1236 | 118 |
| Ex. 7 | Spiral | 4.5-100 | Y-shape | 7.5 | 0.2 | 1.3 | 1.46 | 0.027 | 16 | Y-shape | 2.0 | 1.3 | 5.4 | 54.0 | 48.6 | 2.76 | 0.53 | 0.10 | 0.27 | 1228 | 117 |
| Ex. 8 | Spiral | 4.5-100 | Y-shape | 7.5 | 0.2 | 1.3 | 1.46 | 0.027 | 12 | Y-shape | 2.0 | 1.3 | 5.4 | 54.0 | 48.6 | 2.76 | 0.53 | 0.10 | 0.27 | 1232 | 117 |
| Ex. 9 | Spiral | 4.5-100 | Y-shape | 7.5 | 0.2 | 1.3 | 1.46 | 0.027 | 8 | Y-shape | 2.0 | 1.3 | 5.4 | 41.9 | 36.5 | 2.76 | 0.53 | 0.10 | 0.27 | 1233 | 117 |

| | | | | | | | | | | | | | | | | | | | | | |
|---|---|---|---|---|---|---|---|---|---|---|---|---|---|---|---|---|---|---|---|---|---|
| Ex. 10 | Spiral | 4.5-100 | Y-shape | 7.5 | 0.2 | 1.3 | 1.46 | 0.027 | 8 | Y-shape | 2.0 | 1.3 | 5.4 | 54.0 | 48.6 | 2.76 | 0.53 | 0.10 | 0.27 | 1226 | 117 |
| Ex. 11 | Spiral | 4.5-100 | Y-shape | 7.5 | 0.2 | 1.3 | 1.46 | 0.027 | 8 | Y-shape | 2.0 | 1.3 | 8.1 | 56.8 | 48.7 | 2.76 | 0.53 | 0.10 | 0.27 | 1214 | 116 |
| Ex. 12 | Concentric (eccentric) | 0.5-100 | Y-shape | 7.5 | 0.2 | 1.3 | 1.46 | 0.027 | 8 | Y-shape | 2.0 | 1.3 | 5.4 | 54.0 | 48.6 | 2.76 | 0.53 | 0.10 | 0.27 | 1220 | 116 |
| Ex. 13 | Concentric (non-eccentric) | 4.5-100 | Y-shape | 7.5 | 0.2 | 1.3 | 1.46 | 0.027 | 8 | Y-shape | 2.0 | 1.3 | 5.4 | 54.0 | 48.6 | 2.76 | 0.53 | 0.10 | 0.27 | 1225 | 116 |
| Ex. 14 | Spiral | 4.5-100 | Inverse trapezoidal | 9.5 | 0.5 | 1.3 | 2.34 | 0.053 | 8 | Y-shape | 2.0 | 1.3 | 5.4 | 54.0 | 48.6 | 2.76 | 0.85 | 0.25 | 1.32 | 1213 | 116 |
| Ex. 15 | Spiral | 4.5-100 | Y-shape | 7.5 | 0.2 | 1.3 | 1.46 | 0.027 | 24 | Y-shape | 2.0 | 1.3 | 5.4 | 54.0 | 48.6 | 2.76 | 0.53 | 0.10 | 0.27 | 1220 | 116 |

| | | | | | | | | | | | | | | | | | | | | | |
|---|---|---|---|---|---|---|---|---|---|---|---|---|---|---|---|---|---|---|---|---|---|
| Ex. 16 | Spiral | 4.5-100 | Y-shape | 6.5 | 0.5 | 1.0 | 0.70 | 0.077 | 8 | Y-shape | 0.5 | 1.3 | 5.4 | 54.0 | 48.6 | 0.90 | 0.78 | 1.00 | 7.69 | 1112 | 106 |
| Ex. 17 | Spiral | 4.5-100 | Inverse trapezoidal | 6.0 | 0.3 | 1.3 | 0.64 | 0.050 | 8 | Y-shape | 2.0 | 1.3 | 5.4 | 54.0 | 48.6 | 2.76 | 0.23 | 0.15 | 0.75 | 1198 | 114 |
| Ex. 18 | Spiral | 4.5-100 | Y-shape | 7.5 | 0.2 | 1.3 | 1.46 | 0.027 | 8 | Y-shape | 2.0 | 1.3 | 5.4 | 63.5 | 58.1 | 2.76 | 0.53 | 0.10 | 0.27 | 1162 | 111 |
| Ex. 19 | Spiral | 4.5-100 | Inverse trapezoidal | 6.0 | 0.3 | 1.3 | 1.37 | 0.050 | 8 | Y-shape | 2.0 | 1.3 | 5.4 | 54.0 | 48.6 | 2.76 | 0.49 | 0.15 | 0.75 | 1162 | 111 |
| Ex. 20 | Spiral | 4.5-100 | Y-shape | 7.5 | 0.2 | 1.3 | 1.46 | 0.027 | 4 | Y-shape | 2.0 | 1.3 | 5.4 | 54.0 | 48.6 | 2.76 | 0.53 | 0.10 | 0.27 | 1157 | 110 |
| Ex. 21 | Spiral | 4.5-100 | Inverse trapezoidal | 6.0 | 0.3 | 1.3 | 2.08 | 0.050 | 8 | Y-shape | 2.0 | 1.3 | 5.4 | 54.0 | 48.6 | 2.76 | 0.75 | 0.15 | 0.75 | 1150 | 110 |
| Ex. 22 | Spiral | 4.5-100 | Y-shape | 4.5 | 0.7 | 1.3 | 1.07 | 0.156 | 8 | Inverse trapezoidal | 0.5 | 1.3 | 5.4 | 54.0 | 48.6 | 1.35 | 0.80 | 1.40 | 21.78 | 1110 | 106 |
| Ex. 23 | Spiral | 4.5-100 | Y-shape | 3.0 | 0.7 | 1.3 | 1.07 | 0.233 | 8 | Y-shape | 0.5 | 1.3 | 5.4 | 54.0 | 48.6 | 1.29 | 0.83 | 1.40 | 32.67 | 1105 | 105 |
| Ex. 24 | Spiral | 4.5-100 | Y-shape | 6.0 | 0.2 | 1.3 | 0.62 | 0.033 | 8 | Y-shape | 2.0 | 1.3 | 5.4 | 54.0 | 48.6 | 4.04 | 0.15 | 0.10 | 0.33 | 1090 | 104 |
| Ex. 25 | Spiral | 4.5-100 | Y-shape | 2.3 | 0.7 | 1.3 | 1.07 | 0.311 | 8 | Y-shape | 0.5 | 1.3 | 5.4 | 54.0 | 48.6 | 1.29 | 0.83 | 1.40 | 43.56 | 1080 | 103 |

[Table 2]

| Comparative Example No. | Concentric grooves, spiral groove, or grid-like groove | | | | | | | | Radial grooves (line segment-shaped grooves) | | | | | | | | Sb/Sa | Wb/Wa | $Wb^2/(P*Wa)*100$ [%] | Evaluation results | |
|---|---|---|---|---|---|---|---|---|---|---|---|---|---|---|---|---|---|---|---|---|---|
| | Shape | Ratio of formed region to radius from center of polishing surface (%) | Cross-sectional shape | Groove pitch P (mm) | Groove width Wb (mm) | Groove depth (mm) | Cross-sectional area Sb ($mm^2$) | Wb/P | Number (grooves) | Cross-sectional shape | Groove width Wa (mm) | Groove depth (mm) | Ratio of distance from radial groove center to first end portion to radius of polishing surface (%) | Ratio of distance from radial groove center to second end portion to radius of polishing surface (%) | Ratio of groove length to radius (%) | Cross-sectional area Sa ($mm^2$) | | | | Polishing rate [nm/min] | Polishing rate improvement rate (%) |
| Com. Ex. 1 | Spiral | 4.5-100 | Y-shape | 7.5 | 0.2 | 1.3 | 1.46 | 0.027 | 0 | - | - | - | - | - | - | - | - | - | - | 1004 | 96 |
| Com. Ex. 2 | Spiral | 4.5-100 | Y-shape | 6.0 | 0.3 | 1.3 | 1.39 | 0.050 | 0 | - | - | - | - | - | - | - | - | - | - | 1008 | 96 |
| Com. Ex. 3 | Spiral | 4.5-100 | Inverse trapezoidal | 9.5 | 0.5 | 1.3 | 2.34 | 0.053 | 0 | - | - | - | - | - | - | - | - | - | - | 989 | 94 |
| Com. Ex. 4 | Concentric (eccentric) | 0.5-100 | Inverse trapezoidal | 9.5 | 0.5 | 1.3 | 2.34 | 0.053 | 0 | - | - | - | - | - | - | - | - | - | - | 970 | 92 |
| Com. Ex. 5 | Spiral | 4.5-100 | Y-shape | 7.5 | 0.2 | 1.3 | 1.46 | 0.027 | 8 | Y-shape | 2.0 | 1.3 | 5.4 | 29.7 | 24.3 | 2.76 | 0.53 | 0.10 | 0.27 | 1005 | 96 |
| Com. Ex. 6 | Spiral | 4.5-100 | Y-shape | 7.5 | 0.5 | 1.3 | 1.47 | 0.067 | 8 | Y-shape | 0.5 | 1.3 | 5.4 | 54.0 | 48.6 | 1.29 | 1.14 | 1.00 | 6.67 | 980 | 93 |
| Com. Ex. 7 | Spiral | 4.5-100 | Y-shape | 7.5 | 0.2 | 1.3 | 1.46 | 0.027 | 8 | Y-shape | 2.0 | 1.3 | 5.4 | 100.0 | 94.6 | 2.76 | 0.53 | 0.10 | 0.27 | 902 | 86 |
| Com. Ex. 8 | Spiral | 4.5-100 | Y-shape | 7.5 | 0.2 | 1.3 | 1.46 | 0.027 | 8 | Y-shape | 2.0 | 1.3 | 5.4 | 75.7 | 70.3 | 2.76 | 0.53 | 0.10 | 0.27 | 954 | 91 |
| Com. Ex. 9 | Spiral | 4.5-100 | Y-shape | 7.5 | 0.2 | 1.3 | 1.46 | 0.027 | 8 | Y-shape | 2.0 | 1.3 | 2.7 | 54.0 | 51.3 | 2.76 | 0.53 | 0.10 | 0.27 | 820 | 78 |
| Com. Ex. 10 | Spiral | 4.5-100 | Inverse trapezoidal | 9.5 | 0.5 | 1.3 | 2.34 | 0.053 | 8 | Y-shape | 1.0 | 1.3 | 5.4 | 54.0 | 48.6 | 2.34 | 1.00 | 0.50 | 2.63 | 972 | 93 |

| | | | | | | | | | | | | | | | | | | | | | |
|---|---|---|---|---|---|---|---|---|---|---|---|---|---|---|---|---|---|---|---|---|---|
| Com. Ex. 11 | Grid-like | 0-54 | Rectangular | 10.0 | 0.5 | 1.05 | 0.53 | 0.050 | 0 | - | - | - | - | - | - | - | - | - | - | 505 | 48 |
| Com. Ex. 12 | Grid-like | 0-100 | Rectangular | 10.0 | 0.5 | 1.05 | 0.53 | 0.050 | 0 | - | - | - | - | - | - | - | - | - | - | 320 | 30 |
| Com. Ex. 13 | Spiral | 4.5-100 | Y-shape | 6.0 | 0.5 | 1.3 | 0.90 | 0.900 | 8 | Y-shape | 0.5 | 1.0 | 5.4 | 54.0 | 48.6 | 0.75 | 1.20 | 1 | 90.00 | 978 | 93 |

The polishing pads obtained in Examples 1 to 25 according to the present invention shown in Table 1 all had a high polishing rate. On the other hand, the polishing pads obtained in Comparative Examples 1 to 13 shown in Table 2 all had a low polishing rate. Referring to Table 1, the polishing pads obtained in Examples 1 to 21, each of which satisfied 0.25 ≤ Sb/Sa ≤ 0.85, and 0.2 ≤ $\{Wb^2/(P \times Wa)\} \times 100$ ≤ 21.0, had a particularly high polishing rate.

<Influence of Sb/Sa on Polishing Uniformity>

Twelve polishing pads according to the examples that differed in Sb/Sa were selected. Then, a plurality of silicon wafers were polished in the same manner as in the measurement method described in <Polishing Rate>. Then, the polishing uniformity of each of the polishing pads that had been polished until the groove depth of the polishing layer was reduced by 50% from the groove depth of the unused polishing layer was evaluated in the following manner.

The thicknesses of the silicon oxide film before and after polishing of the silicon wafer polished when the groove depth of the annular grooves of the polishing layer had been reduced by 50% were measured at 49 points in the wafer plane (edge exclusion: 3 mm), and the polishing rate (nm/min) at each of the points was determined. Then, the average value and the standard deviation 1σ of the polishing rates at the 49 points were calculated, and a coefficient of variation (unit: %) was determined from the calculated average value and standard deviation 1σ. The smaller the coefficient of variation, the better the indicated polishing uniformity. Sb/Sa, and the evaluation results of the polishing rate and the polishing uniformity are shown in Table 3 below.

[Table 3]

| Example No. | Sb/Sa | Evaluation results | | |
|---|---|---|---|---|
| | | Polishing rate [nm/min] | Polishing rate improvement rate (%) | Polishing uniformity when groove depth has decreased from initial groove depth by 50% (coefficient of variation: %) |
| Ex. 25 | 0.15 | 1102 | 105 | 4.9 |
| Ex. 6 | 0.28 | 1236 | 118 | 3.9 |
| Ex. 5 | 0.39 | 1242 | 118 | 3.8 |
| Ex. 4 | 0.44 | 1265 | 120 | 2.8 |
| Ex. 2 | 0.46 | 1364 | 130 | 1.8 |
| Ex. 10 | 0.53 | 1226 | 117 | 2.1 |
| Ex. 16 | 0.78 | 1210 | 115 | 3.3 |
| Ex. 3 | 0.80 | 1270 | 121 | 2.3 |
| Ex. 14 | 0.85 | 1213 | 116 | 4.3 |
| Com. Ex. 10 | 1.00 | 972 | 93 | 7.2 |
| Com. Ex. 6 | 1.14 | 980 | 93 | 8.5 |
| Com. Ex. 13 | 1.20 | 978 | 93 | 9.0 |

Referring to Table 3, it can be seen that Examples 4, 2, 10, 16, and 3, each of which satisfied 0.44 ≤ Sb/Sa ≤ 0.80, had a coefficient of variation of the polishing uniformity of as low as 2.8% or less, particularly excellent polishing uniformity, and also a high polishing rate.

[Examples 26 to 28]

Polishing pads (Examples 26, 27, and 28) were formed in the same manner as in Example 10 except for respectively using the polishing layer sheet having a D hardness of 86, obtained in Production Example 2, the polishing layer sheet having a D hardness of 56, obtained in Production Example 3, and the polishing layer sheet having a D hardness of 49, obtained in Production Example 4. Then, the influence of the D hardness of the polishing layer on the polishing uniformity was investigated.
The evaluation results of the influence of the D hardness of the polishing layer on the polishing uniformity are shown in Table 3.

[Table 4]

| Example No. | Sb/Sa | Wb/Wa | $Wb^2$/(P*Wa) *100 [%] | D hardness | Evaluation results |
|---|---|---|---|---|---|
| | | | | | Polishing uniformity when groove depth has decreased from initial groove depth by 50% |
| Ex. 26 | 0.53 | 0.10 | 0.27 | 86 | 2.3 |
| Ex. 10 | 0.53 | 0.10 | 0.27 | 62 | 2.1 |
| Ex. 27 | 0.53 | 0.10 | 0.27 | 56 | 3.8 |
| Ex. 28 | 0.53 | 0.10 | 0.27 | 46 | 5.2 |

Referring to Table 4, it can be seen that the polishing pad using the polishing layer of Example 10, 26, or 27, each of which had a JIS D hardness in the range of 56 to 86, had a significantly low coefficient of variation of the polishing uniformity, and particularly excellent polishing uniformity, as compared with the polishing layer of Example 28, which had a JIS D hardness of 46.

[Examples 29 to 39 and Comparative Examples 14 to 24]

Grooves having the shapes of patterns described in Tables 5 and 6 were formed through machining on a polishing surface constituting one surface of the polishing layer sheet obtained in Production Example 1. In Examples 30 and 32, concentric grooves in which the center of concentric circles was eccentric to the center of the polishing surface by 15 mm were formed. At this time, the center of the concentric grooves was at a position away from the center of the polishing surface by a distance of about 4% of the radius of the polishing surface. The center of the radial grooves coincided with the center of the concentric grooves. The grooves in each of the examples had a Y-shape formed by chamfering corners of a rectangular cross section, an inverse trapezoidal shape, or a rectangular shape. Then, the groove width, the groove cross-sectional area, the groove pitch, and the groove depth of the each of the grooves were measured in the same manner as described above.
Then, a cushioning layer was attached to the back surface of the polishing layer as opposed to the polishing surface with a double-sided pressure-sensitive adhesive sheet, to form a multilayer polishing pad. As the cushioning layer, a "Poron H48" manufactured by INOAC Corporation, a foamed polyurethane sheet having a thickness of 0.8 mm, was used. Then, the polishing characteristics of the obtained polishing pad were evaluated by the following evaluation methods.

<Polishing Rate>

The obtained polishing pad was attached to a polishing apparatus "FREX-300" manufactured by EBARA CORPORATION. Then, a slurry obtained by diluting two-fold a slurry "SEMI-SPERSE 25" manufactured by Cabot Microelectronics was prepared, and a 12-inch-diameter silicon wafer having a silicon oxide film with a thickness of 2000 nm on the surface thereof was polished for 60 seconds at a platen rotation rate of 100 rpm, a head rotation rate of 99 rpm, and a polishing pressure of 20.0 kPa, while supplying the slurry onto the polishing surface of the polishing pad at a rate of 200 mL/min.
Then, using a pad conditioner (a diamond dresser (diamond grit: #100, blocky, metal base diameter: 19 cm) manufactured by A.L.M.T. Corp.), the surface of the polishing pad was conditioned for 30 seconds at a dresser rotation rate of 70 rpm, a polishing pad rotation rate of 100 rpm, and a dresser load of 20 N, while pouring pure water at a rate of 150 mL/min. Then, another silicon wafer was polished with the polishing pad, and the polishing pad was further conditioned for 30 seconds. Then, after being polished for 60 seconds, the polishing pad was conditioned for 30 seconds. Then, another silicon wafer was polished with the polishing pad, and the polishing pad was further conditioned for 30 seconds. In this

manner, 10 silicon wafers were polished.

Then, the thicknesses before and after polishing of the silicon oxide film on the tenth silicon wafer that had been polished were measured at 49 points in the wafer plane, and the polishing rate (Å/min) at each of the points was determined. Specifically, the average value of the polishing rates at the 49 points was used as a polishing rate.

Based on a polishing rate of 2400 Å/min, which has been achievable using typical conventional groove shapes, the improvement rate of the polishing rate of each of the examples was calculated using the following equation:

$$\text{Improvement rate (\%) of polishing rate} = \text{Polishing rate} \div 2400 \times 100$$

The results are shown in Tables 5 and 6.

[Table 5]

| Example No. | Concentric grooves, spiral groove, or grid-like groove | | | | | | | | Radial grooves (line segment-shaped grooves) | | | | | | | | Sb/Sa | Wb/Wa | $Wb^2/(P*Wa)*100$ [%] | Evaluation results | |
|---|---|---|---|---|---|---|---|---|---|---|---|---|---|---|---|---|---|---|---|---|---|
| | Shape | Ratio of formed region to radius from center of polishing surface (%) | Cross-sectional shape | Groove pitch P (mm) | Groove width Wb (mm) | Groove depth (mm) | Cross-sectional area Sb ($mm^2$) | Wb/P | Number (grooves) | Cross-sectional shape | Groove width Wa (mm) | Groove depth (mm) | Ratio of distance from radial groove center to first end portion to radius of polishing surface (%) | Ratio of distance from radial groove center to second end portion to radius of polishing surface (%) | Ratio of groove length to radius (%) | Cross-sectional area Sa ($mm^2$) | | | | Polishing rate [Å/min] | Polishing rate improvement rate (%) |
| Ex. 29 | Spiral | 4.5-100 | Y-shape | 2.00 | 0.30 | 1.05 | 0.338 | 0.150 | 8 | Rectangular | 0.50 | 1.05 | 5.4 | 54 | 48.6 | 0.525 | 0.64 | 0.60 | 9.00 | 2850 | 119 |
| Ex. 30 | Concentric (eccentric) | 0.5-100 | Y-shape | 2.00 | 0.30 | 1.05 | 0.338 | 0.150 | 8 | Rectangular | 0.50 | 1.05 | 5.4 | 54 | 48.6 | 0.525 | 0.64 | 0.60 | 9.00 | 2800 | 117 |
| Ex. 31 | Spiral | 4.5-100 | Rectangular | 3.00 | 0.30 | 1.05 | 0.315 | 0.100 | 8 | Inverse trapezoidal | 0.50 | 1.05 | 5.4 | 54 | 48.6 | 0.926 | 0.34 | 0.60 | 6.00 | 2885 | 120 |

| | | | | | | | | | | | | | | | | | | | | | |
|---|---|---|---|---|---|---|---|---|---|---|---|---|---|---|---|---|---|---|---|---|---|
| Ex. 32 | Concentric (eccentric) | 0.5-100 | Y-shape | 3.00 | 0.30 | 1.05 | 0.338 | 0.100 | 8 | Rectangular | 0.50 | 1.05 | 5.4 | 54 | 48.6 | 0.525 | 0.64 | 0.60 | 6.00 | 2883 | 120 |
| Ex. 33 | Spiral | 4.5-100 | Y-shape | 3.00 | 0.30 | 1.05 | 0.338 | 0.100 | 4 | Rectangular | 0.50 | 1.05 | 5.4 | 54 | 48.6 | 0.525 | 0.64 | 0.60 | 6.00 | 2730 | 114 |
| Ex. 34 | Spiral | 4.5-100 | Y-shape | 3.00 | 0.30 | 1.05 | 0.338 | 0.100 | 12 | Inverse trapezoidal | 0.50 | 1.05 | 5.4 | 54 | 48.6 | 0.525 | 0.64 | 0.60 | 6.00 | 2670 | 111 |
| Ex. 35 | Spiral | 4.5-100 | Y-shape | 3.00 | 0.30 | 1.05 | 0.338 | 0.100 | 16 | Rectangular | 0.50 | 1.05 | 5.4 | 54 | 48.6 | 0.525 | 0.64 | 0.60 | 6.00 | 2950 | 123 |
| Ex. 36 | Spiral | 4.5-100 | Y-shape | 3.00 | 0.30 | 1.05 | 0.337 | 0.100 | 16 | Rectangular | 2.00 | 1.05 | 5.4 | 54 | 48.6 | 2.100 | 0.16 | 0.15 | 1.50 | 2800 | 117 |
| Ex. 37 | Spiral | 4.5-100 | Y-shape | 6.00 | 0.30 | 1.05 | 0.338 | 0.050 | 8 | Rectangular | 0.50 | 1.05 | 5.4 | 54 | 48.6 | 0.525 | 0.64 | 0.60 | 3.00 | 2710 | 113 |
| Ex. 38 | Spiral | 4.5-100 | Y-shape | 2.00 | 0.20 | 1.05 | 0.333 | 0.100 | 8 | Y-shape | 0.50 | 1.05 | 5.4 | 54 | 48.6 | 0.525 | 0.63 | 0.40 | 4.00 | 2650 | 110 |
| Ex. 39 | Spiral | 4.5-100 | Y-shape | 3.00 | 0.45 | 1.05 | 0.495 | 0.150 | 8 | Rectangular | 0.50 | 1.05 | 5.4 | 54 | 48.6 | 0.525 | 0.94 | 0.90 | 13.50 | 2598 | 108 |

[Table 6]

| Example No. | Concentric grooves, spiral groove, or grid-like groove | | | | | | | | Radial grooves (line segment-shaped grooves) | | | | | | | | Sb/Sa | Wb/Wa | Wb²/(P*Wa)*100 [%] | Evaluation results | |
|---|---|---|---|---|---|---|---|---|---|---|---|---|---|---|---|---|---|---|---|---|---|
| | Shape | Ratio of formed region to radius from center of polishing surface (%) | Cross-sectional shape | Groove pitch P (mm) | Groove width Wb (mm) | Groove depth (mm) | Cross-sectional area Sb (mm²) | Wb/P | Number (grooves) | Cross-sectional shape | Groove width Wa (mm) | Groove depth (mm) | Ratio of distance from radial groove center to first end portion to radius of polishing surface (%) | Ratio of distance from radial groove center to second end portion to radius of polishing surface (%) | Ratio of groove length to radius (%) | Cross-sectional area Sa (mm²) | | | | Polishing rate (Å/min) | Polishing rate improvement rate (%) |
| Com. Ex. 14 | Spiral | 4.5-100 | Y-shape | 6.00 | 0.30 | 1.05 | 0.338 | 0.050 | 0 | - | - | - | - | - | - | - | - | - | - | 2350 | 98 |
| Com. Ex. 15 | Spiral | 4.5-100 | Rectangular | 3.00 | 0.30 | 1.05 | 0.315 | 0.100 | 0 | - | - | - | - | - | - | - | - | - | - | 2250 | 94 |
| Com. Ex. 16 | Spiral | 4.5-100 | Y-shape | 2.50 | 0.80 | 1.05 | 0.963 | 0.320 | 8 | Rectangular | 0.50 | 1.05 | 5.4 | 54 | 48.6 | 0.525 | 1.83 | 1.60 | 51.20 | 2340 | 98 |
| Com. Ex. 17 | Spiral | 4.5-100 | Y-shape | 3.50 | 0.50 | 1.05 | 0.648 | 0.143 | 8 | Rectangular | 0.50 | 1.05 | 5.4 | 54 | 48.6 | 0.525 | 1.23 | 1.00 | 14.29 | 2340 | 98 |
| Com. Ex. 18 | Spiral | 4.5-100 | Y-shape | 2.25 | 0.70 | 1.05 | 0.758 | 0.311 | 8 | Rectangular | 0.50 | 1.05 | 5.4 | 54 | 48.6 | 0.525 | 1.44 | 1.40 | 43.56 | 2310 | 96 |
| Com. Ex. 19 | Spiral | 4.5-100 | Y-shape | 3.00 | 0.70 | 1.05 | 0.758 | 0.233 | 8 | Rectangular | 0.50 | 1.05 | 5.4 | 54 | 48.6 | 0.525 | 1.44 | 1.40 | 32.67 | 2360 | 98 |
| Com. Ex. 20 | Spiral | 4.5-100 | Y-shape | 3.00 | 0.30 | 1.05 | 0.338 | 0.100 | 8 | Rectangular | 0.50 | 1.05 | 2.7 | 54 | 51.3 | 0.525 | 0.64 | 0.60 | 6.00 | 2302 | 96 |
| Com. Ex. 21 | Spiral | 4.5-100 | Y-shape | 3.00 | 0.30 | 1.05 | 0.338 | 0.100 | 8 | Rectangular | 0.50 | 1.05 | 5.4 | 76 | 70.3 | 0.525 | 0.64 | 0.60 | 6.00 | 2292 | 96 |
| Com. Ex. 22 | Spiral | 4.5-100 | Y-shape | 3.00 | 0.30 | 1.05 | 0.338 | 0.100 | 8 | Rectangular | 0.50 | 1.05 | 5.4 | 100 | 94.6 | 0.525 | 0.64 | 0.60 | 6.00 | 2288 | 95 |
| Com. Ex. 23 | Spiral | 4.5-100 | Y-shape | 3.00 | 0.30 | 1.05 | 0.338 | 0.100 | 16 | Rectangular | 0.50 | 1.05 | 5.4 | 100 | 94.6 | 0.525 | 0.64 | 0.60 | 6.00 | 2280 | 95 |
| Com. Ex. 24 | Grid-like | 0-100 | Rectangular | 10.00 | 0.50 | 1.05 | 0.525 | 0.050 | 0 | - | - | - | - | - | - | - | - | - | - | 1050 | 44 |

The polishing pads obtained in Examples 29 to 39 according to the present invention shown in Table 5 all had a

high polishing rate. On the other hand, the polishing pads obtained in Comparative Examples 14 to 24 shown in Table 6 all had a low polishing rate. Referring to Table 5, the polishing pads obtained in Examples 28 to 37, each of which satisfied $0.1 \leq Wb/Wa < 1.0$, and $0.2 \leq \{Wb^2/(P \times Wa)\} \times 100 \leq 10$, had a particularly high polishing rate.

[Reference Signs List]

1, 11. ... Polishing layer
10, 20. ... Polishing pad
E1. ... First end portion
E2. ... Second end portion
C1 to C9. ... Annular grooves (concentric grooves)
S1 to S8. ... Line segment-shaped grooves (radial grooves)
H. ... Spiral groove
F. ... Polishing surface

## Claims

**1.** A polishing pad (10, 20) comprising a polishing layer (1, 11) having a circular polishing surface,

wherein the polishing surface comprises a central region corresponding to a range of 0 to 10% of a radius of the polishing surface from a center of the polishing surface, and a peripheral edge region corresponding to a range of 90 to 100% of the radius of the polishing surface from the center of the polishing surface,
the polishing layer comprises:

at least one spiral groove (H) or concentric grooves (C1 to C11) including a plurality of annular grooves arranged concentrically, the at least one spiral groove and the concentric grooves being disposed spanning from the central region to the peripheral edge region; and
radial grooves including at least two line segment-shaped grooves (S1 to S8) extending from the central region toward the peripheral edge region,

a center of the spiral groove, a center of the concentric grooves, and a center of the radial grooves are present in the central region,
the line segment-shaped grooves (S1 to S8) have an average length of 30 to 65% of the radius of the polishing surface, and have a first end portion (E1) in a region at a distance of 5 to 10% of the radius of the polishing surface from the center of the radial grooves and a second end portion (E2) in a region at a distance of 35 to 70% of the radius of the polishing surface from the center of the radial grooves, and
a cross-sectional area Sa ($mm^2$), which is an average cross-sectional area of cross sections of the line segment-shaped grooves in a direction perpendicular to a length direction of the line segment-shaped grooves (S1 to S8), and a cross-sectional area Sb ($mm^2$), which is an average cross-sectional area of cross sections of the spiral groove (H) or the concentric grooves (C1 to C11) in a direction perpendicular to a tangential direction of the spiral groove or the concentric grooves, satisfy $0.1 \leq Sb/Sa < 1.0$.

**2.** The polishing pad according to claim 1,
wherein $0.25 \leq Sb/Sa \leq 0.85$ is satisfied.

**3.** The polishing pad according to claim 1,
wherein $0.44 \leq Sb/Sa \leq 0.80$ is satisfied.

**4.** The polishing pad according to any one of claims 1 to 3,
wherein a groove width Wa (mm), which is an average width of the line segment-shaped grooves, and a groove width Wb (mm), which is an average width of the spiral groove or the concentric grooves, satisfy $0.1 \leq Wb/Wa < 1.0$.

**5.** The polishing pad according to any one of claims 1 to 4,
wherein a groove width Wb (mm), which is an average width of the spiral groove or the concentric grooves, and an average groove pitch P (mm) of the spiral groove or the concentric grooves, satisfy $0.02 \leq Wb/P \leq 0.25$.

6. The polishing pad according to any one of claims 1 to 5, wherein a groove width Wa (mm), which is an average width of the line segment-shaped grooves, a groove width Wb (mm), which is an average width of the spiral groove or the concentric grooves, and an average groove pitch P (mm) of the spiral groove or the concentric grooves, satisfy $0.2 \leq \{Wb^2/(P \times Wa)\} \times 100 \leq 25$.

7. The polishing pad according to any one of claims 1 to 6, wherein the polishing pad comprises the spiral groove.

8. The polishing pad according to any one of claims 1 to 7, wherein the polishing pad comprises the concentric grooves.

9. The polishing pad according to any one of claims 1 to 8, wherein the polishing layer comprises a thermoplastic polyurethane.

10. The polishing pad according to any one of claims 1 to 9, wherein the polishing layer is a non-foam.

11. The polishing pad according to any one of claims 1 to 10, wherein the polishing layer has a JIS D hardness of 45 to 90.

12. The polishing pad according to any one of claims 1 to 11, wherein the polishing layer has a density of 1.00 to 1.20 g/cm$^3$.

## Patentansprüche

1. Ein Polierkissen (10, 20), umfassend eine Polierschicht (1, 11) mit einer kreisförmigen Polieroberfläche,

wobei die Polieroberfläche einen mittleren Bereich entsprechend einem Bereich von 0 bis 10% eines Radius der Polieroberfläche von einer Mitte der Polieroberfläche , und einen peripheren Randbereich entsprechend einem Bereich von 90 bis 100% des Radius der Polieroberfläche von der Mitte der Polieroberfläche, umfasst,
wobei die Polierschicht umfasst:

mindestens eine spiralförmige Rille (H) oder konzentrische Rillen (C1 bis C11), die eine Mehrzahl konzentrisch angeordneter ringförmiger Rillen beinhalten, wobei die mindestens eine spiralförmige Rille und die konzentrischen Rillen so angeordnet sind, dass sie sich von dem mittleren Bereich zu dem peripheren Randbereich erstrecken; und
radiale Rillen, die mindestens zwei liniensegmentförmige Rillen (S1 bis S8) beinhalten, die sich von dem mittleren Bereich hin zu dem peripheren Randbereich erstrecken,
eine Mitte der spiralförmigen Rille, eine Mitte der konzentrischen Rillen und eine Mitte der radialen Rillen in dem mittleren Bereich vorliegen,
die liniensegmentförmigen Rillen (S1 bis S8) eine durchschnittliche Länge von 30 bis 65% des Radius der Polieroberfläche aufweisen, und einen ersten Endabschnitt (E1) in einem Bereich in einem Abstand von 5 bis 10% des Radius der Polieroberfläche von der Mitte der radialen Rillen sowie einen zweiten Endabschnitt (E2) in einem Bereich in einem Abstand von 35 bis 70% des Radius der Polieroberfläche von der Mitte der radialen Rillen aufweisen, und
eine Querschnittsfläche Sa (mm$^2$), die eine durchschnittliche Querschnittsfläche von Querschnitten der liniensegmentförmigen Rillen in einer Richtung senkrecht zu einer Längsrichtung der liniensegmentförmigen Rillen (S1 bis S8) ist, und eine Querschnittsfläche Sb (mm$^2$), die eine durchschnittliche Querschnittsfläche von Querschnitten der spiralförmigen Rille (H) oder der konzentrischen Rillen (C1 bis C11) in einer Richtung senkrecht zu einer Tangentialrichtung der spiralförmigen Rille oder der konzentrischen Rillen ist, $0,1 \leq Sb/Sa < 1,0$ erfüllen.

2. Das Polierkissen nach Anspruch 1, wobei $0,25 \leq Sb/Sa \leq 0,85$ erfüllt ist.

3. Das Polierkissen nach Anspruch 1, wobei $0,44 \leq Sb/Sa \leq 0,80$ erfüllt ist.

4. Das Polierkissen nach einem der Ansprüche 1 bis 3, wobei eine Rillenbreite Wa (mm), die eine durchschnittliche Breite der liniensegmentförmigen Rillen ist, und eine Rillenbreite Wb (mm), die eine durchschnittliche Breite der spiralförmigen Rille oder der konzentrischen Rillen ist, $0,1 \leq Wb/Wa < 1,0$ erfüllen.

5. Das Polierkissen nach einem der Ansprüche 1 bis 4, wobei eine Rillenbreite Wb (mm), die eine durchschnittliche Breite der spiralförmigen Rille oder der konzentrischen Rillen ist, und ein durchschnittlicher Rillenabstand P (mm) der spiralförmigen Rille oder der konzentrischen Rillen, $0,02 \leq Wb/P \leq 0,25$ erfüllen.

6. Das Polierkissen nach einem der Ansprüche 1 bis 5, wobei eine Rillenbreite Wa (mm), die eine durchschnittliche Breite der liniensegmentförmigen Rillen ist, eine Rillenbreite Wb (mm), die eine durchschnittliche Breite der spiralförmigen Rille oder der konzentrischen Rillen ist, und ein durchschnittlicher Rillenabstand P (mm) der spiralförmigen Rille oder der konzentrischen Rillen, $0,2 \leq \{Wb^2/(P \times Wa)\} \times 100 \leq 25$ erfüllen.

7. Das Polierkissen nach einem der Ansprüche 1 bis 6, wobei das Polierkissen die spiralförmige Rille umfasst.

8. Das Polierkissen nach einem der Ansprüche 1 bis 7, wobei das Polierkissen die konzentrischen Rillen umfasst.

9. Das Polierkissen nach einem der Ansprüche 1 bis 8, wobei die Polierschicht ein thermoplastisches Polyurethan umfasst.

10. Das Polierkissen nach einem der Ansprüche 1 bis 9, wobei die Polierschicht kein Schaumstoff ist.

11. Das Polierkissen nach einem der Ansprüche 1 bis 10, wobei die Polierschicht eine JIS-D-Härte von 45 bis 90 aufweist.

12. Das Polierkissen nach einem der Ansprüche 1 bis 11, wobei die Polierschicht eine Dichte von 1,00 bis 1,20 g/cm$^3$ aufweist.

## Revendications

1. Tampon de polissage (10, 20) comprenant une couche de polissage (1, 11) ayant une surface de polissage circulaire, dans lequel

   la surface de polissage comprend une région centrale correspondant à une plage de 0 à 10 % du rayon de la surface de polissage depuis le centre de la surface de polissage, et une région de bord périphérique correspondant à une plage de 90 à 100 % du rayon de la surface de polissage depuis le centre de la surface de polissage,
   la couche de polissage comprend :

      au moins une rainure en spirale (H) ou des rainures concentriques (C1 à C11) incluant une pluralité de rainures annulaires disposées concentriquement, l'au moins une rainure en spirale et les rainures concentriques étant disposées en couvrant de la région centrale à la région de bord périphérique ; et
      des rainures radiales incluant au moins deux rainures en forme de segment de droite (S1 à S8) s'étendant depuis la région centrale en direction de la région de bord périphérique,
      un centre de la rainure en spirale, un centre des rainures concentriques, et un centre des rainures radiales sont présents dans la région centrale,
      les rainures en forme de segment de droite (S1 à S8) ont une longueur moyenne de 30 à 65 % du rayon de la surface de polissage, et ont une première partie d'extrémité (E1) dans une région à une distance de 5 à 10 % du rayon de la surface de polissage depuis le centre des rainures radiales et une deuxième partie d'extrémité (E2) dans une région à une distance de 35 à 70 % du rayon de la surface de polissage depuis le centre des rainures radiales, et

une superficie en coupe transversale Sa ($mm^2$), qui est une superficie en coupe transversale moyenne de sections transversales des rainures en forme de segment de droite dans une direction perpendiculaire à la direction d'une longueur des rainures en forme de segment de droite (S1 à S8), et une superficie en coupe transversale Sb ($mm^2$), qui est une superficie en coupe transversale moyenne de sections transversales d'une rainure en spirale (H) ou des rainures concentriques (C1 à C11) dans une direction perpendiculaire à la direction tangentielle de la rainure en spirale ou des rainures concentriques, satisfont à l'inégalité $0,1 \leq Sb/Sa < 1,0$.

**2.** Tampon de polissage selon la revendication 1, dans lequel $0,25 \leq Sb/Sa \leq 0,85$ est satisfait.

**3.** Tampon de polissage selon la revendication 1, dans lequel $0,44 \leq Sb/Sa \leq 0,80$ est satisfait.

**4.** Tampon de polissage selon l'une quelconque des revendications 1 à 3, dans lequel la largeur de rainure Wa (mm), qui est la largeur moyenne des rainures en forme de segment de droite, et la largeur de rainure Wb (mm), qui est la largeur moyenne de la rainure en spirale ou des rainures concentriques, satisfont à $0,1 \leq Wb/Wa < 1,0$.

**5.** Tampon de polissage selon l'une quelconque des revendications 1 à 4, dans lequel la largeur de rainure Wb (mm), qui est la largeur moyenne de la rainure en spirale ou des rainures concentriques, et le pas de rainure moyen P (mm) de la rainure en spirale ou des rainures concentriques, satisfont à $0,02 \leq Wb/P \leq 0,25$.

**6.** Tampon de polissage selon l'une quelconque des revendications 1 à 5, dans lequel la largeur de rainure Wa (mm), qui est la largeur moyenne des rainures en forme de segment de droite, la largeur de rainure Wb (mm), qui est la largeur moyenne de la rainure en spirale ou des rainures concentriques, et le pas de rainure moyen P (mm) de la rainure en spirale ou des rainures concentriques, satisfont à $0,2 \leq \{Wb^2/(P \times Wa)\} \times 100 \leq 25$.

**7.** Tampon de polissage selon l'une quelconque des revendications 1 à 6, lequel tampon de polissage comprend la rainure en spirale.

**8.** Tampon de polissage selon l'une quelconque des revendications 1 à 7, lequel tampon de polissage comprend les rainures concentriques.

**9.** Tampon de polissage selon l'une quelconque des revendications 1 à 8, dans lequel la couche de polissage comprend un polyuréthane thermoplastique.

**10.** Tampon de polissage selon l'une quelconque des revendications 1 à 9, dans lequel la couche de polissage n'est pas une mousse.

**11.** Tampon de polissage selon l'une quelconque des revendications 1 à 10, dans lequel la couche de polissage a une dureté JIS D de 45 à 90.

**12.** Tampon de polissage selon l'une quelconque des revendications 1 à 11, dans lequel la couche de polissage a une masse volumique de 1,00 à 1,20 $g/cm^3$.

Fig.1

10
S2
S1
S8
G
S7
S3
H
K1
S6
S4
K2
E2
E1
S5

Fig.2

S2
S1
S8
20
C11
C10
C9
G
S7
K2
C8
S3
C7
K1
S6
E1
C6
E2
S4
C5
C1
C4
C2
C3
S5

Fig.3A

P (mm)
Wb (mm)
Sb (mm2)

Fig.3B

α
α

Fig.3C

α
α

Fig.4

Wa (mm)
Sa (mm²)

Fig.5

10, 20
F
1, 11
6
7

Fig.6

102
100
103
60
50
104
10
101

R1
G
10
R2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000237950 A
- JP 2011177884 A
- JP 2017208530 A
- TW M459065 U1
- TW I548484
- TW M612568 U
- CN 205996788 U